# EUROPEAN PATENT APPLICATION

(11) **EP 4 576 193 A1**
(43) Date of publication of application: **25.06.2025**
(21) Application number: 24207767.5
(22) Date of filing: 21.10.2024
(51) Int. Cl.: H01L 23/00, H01L 25/065, H01L 23/528, H01L 23/48

(54) **PACKAGE ARCHITECTURES HAVING VERTICALLY STACKED DIES AND VOLTAGE DOMAIN STACKING**

(30) Priority: 20.12.2023 US 202318390357
(71) Applicant: INTEL Corporation, Santa Clara, CA 95054 (US)
(72) Inventor: Butzen, Nicolas, Portland, OR 97225 (US); Heinemann, Erich, Canby, OR 97013 (US); Radhakrishnan, Kaladhar, Chandler, AZ 85226 (US); Suthram, Sagar, Portland, OR 97229 (US); Gomes, Wilfed, Portland, OR 97229 (US); Mahajan, Ravindranath, Chandler, AZ 85248 (US); Hwang, Jack, Oregon City, OR 97045 (US); Mongia, Rajiv, Portland, OR 97229 (US)
(74) Representative: Goddar, Heinz J.

(57) **Abstract**

Embodiments of an integrated circuit (IC) die may include a substrate having a first surface with an array of first conductive pads, an opposite second surface, a third surface orthogonal to first and second surfaces, and through substrate vias (TSVs) electrically coupled to the array of first conductive pads; and a metallization stack having a fourth surface, an opposite fifth surface, and a sixth surface orthogonal to the fourth and fifth surfaces, and including a conductive trace parallel to the fourth and fifth surfaces and exposed at the sixth surface, and conductive vias between the fourth and fifth surfaces and exposed at the fifth surface, wherein the second surface of the substrate is coupled to the fourth surface of the metallization stack and an interface between the substrate and the metallization stack includes an array of second conductive pads electrically coupled to the conductive trace and conductive vias.

## Description

### BACKGROUND

Electronic circuits when commonly fabricated on a wafer of semiconductor material, such as silicon, are called integrated circuits (ICs). The wafer with such ICs is typically cut into numerous individual dies. The dies may be packaged into an IC package containing one or more dies along with other electronic components such as resistors, capacitors, and inductors. The IC package may be integrated onto an electronic system, such as a consumer electronic system, or servers, such as mainframes.

### BRIEF DESCRIPTION OF THE DRAWINGS

Embodiments will be readily understood by the following detailed description in conjunction with the accompanying drawings. To facilitate this description, like reference numerals designate like structural elements. Embodiments are illustrated by way of example, and not by way of limitation, in the figures of the accompanying drawings.
FIG. 1 is a schematic cross-sectional view of an example IC die according to some embodiments of the present disclosure.
FIG. 2 is a schematic perspective view of the example IC die of FIG. 1 according to some embodiments of the present disclosure.
FIG. 3A is a schematic cross-sectional view of an example microelectronic assembly according to some embodiments of the present disclosure.
FIG. 3B is a schematic cross-sectional view of a portion of the example microelectronic assembly of FIG. 3A.
FIG. 3C is a schematic cross-sectional view of a portion of the example microelectronic assembly of FIG. 3A according to some embodiments of the present disclosure.
FIG. 3D is a schematic cross-sectional view of a portion of the example microelectronic assembly of FIG. 3A according to some embodiments of the present disclosure.
FIG. 4 is a schematic perspective view of an example microelectronic assembly including the example IC die of FIG. 2 according to some embodiments of the present disclosure.
FIGS. 5A-5D are schematic cross-sectional views of example IC die according to some embodiments of the present disclosure.
FIG. 6A is a schematic cross-sectional view of an example microelectronic assembly according to some embodiments of the present disclosure.
FIG. 6B is a simplified circuit diagram of the microelectronic assembly of FIG. 6A according to some embodiments of the present disclosure.
FIG. 7 is a schematic cross-sectional view of an example microelectronic assembly according to some embodiments of the present disclosure.
FIG. 8A is a schematic cross-sectional view of an example microelectronic assembly according to some embodiments of the present disclosure.
FIG. 8B is a magnified portion of the microelectronic assembly of FIG. 8A according to some embodiments of the present disclosure.
FIG. 8C is a simplified circuit diagram of the microelectronic assembly of FIG. 8A according to some embodiments of the present disclosure.
FIG. 9 is a cross-sectional view of a device package that includes one or more microelectronic assemblies in accordance with any of the embodiments disclosed herein.
FIG. 10 is a cross-sectional side view of a device assembly that includes one or more microelectronic assemblies in accordance with any of the embodiments disclosed herein.
FIG. 11 is a block diagram of an example computing device that includes one or more microelectronic assemblies in accordance with any of the embodiments disclosed herein.

### DETAILED DESCRIPTION

### Overview

For purposes of illustrating IC packages described herein, it is important to understand phenomena that may come into play during assembly and packaging of ICs. The following foundational information may be viewed as a basis from which the present disclosure may be properly explained. Such information is offered for purposes of explanation only and, accordingly, should not be construed in any way to limit the broad scope of the present disclosure and its potential applications.

The trend in the computer industry is to utilize multiple processors in large servers, the multiple processors being coupled together in a single package, such as a Multi-Chip Module (MCM). The multiple processors along with other IC dies containing memory circuits (e.g., cache memory circuits, high-bandwidth memory circuits, etc.) are interconnected by high-speed data buses in the package substrate of the MCM, for example, to enable the totality of processors to operate together. However, current technology in such MCMs is inherently limited in its ability to scale to the bandwidth/distance requirements of next generation servers that could have signal speeds greater than 10 GHz and/or data speeds of 3-10 Terabytes per second. The limitations are primarily associated with bandwidth reduction, signal delay, signal loss, and signal distortion due to various reasons, one of which is the configuration in which the multiple processors are coupled together inside the package.

Current packaging architecture, whether 2D, 2.5D or 3D, utilizes multiple IC dies that are oriented parallel to each other and interconnected by various kinds of interconnects, such as copper microbumps, solder balls, etc. In a general sense, any typical IC die consists of a substrate, an active region in the substrate comprising transistors and other active circuitry, and a metallization stack over the substrate, sharing a contact area with the active region. The metallization stack is the region of the IC die in which the individual devices (e.g., transistors, capacitors, resistors, etc.) are interconnected with conductive traces and conductive vias. Common metals used for the conductive traces and conductive vias are copper and aluminum. The metallization stack typically includes contact pads, insulating layers (e.g., interlayer dielectric (ILD) materials such as silicon oxide), conductive layers comprising the conductive traces, and bonding sites for chip-to-chip or chip-to-package connections. Modern IC dies may include more than ten (10) conductive layers in the metallization stack.

Conventionally, various such IC dies may be stacked within a package in various ways: (1) back-to-back, in which the substrate of one IC die is in direct contact with the substrate of another IC die; (2) back-to-front, in which the substrate of one IC die is in direct contact with the metallization stack of the other IC die; and (3) front-to-front, in which the metallization stacks of the two IC dies are in direct contact. In all these configurations, the IC dies are mutually parallel to each other, with the active circuitry disposed in planes parallel to the contacting areas of adjacent IC dies. Such architecture suffers from certain inherent limitations. For example, compute IC dies comprising high-performance compute circuitry that generates a lot of heat have to be placed on the top of any such stack so that heat can be dissipated properly. Such placement limits the number of high-power compute IC dies that can be placed in a package having a limited (or constrained) footprint.

Microelectronic assemblies disclosed herein may include IC dies that are vertically stacked and electrically coupled at a lateral edge (e.g., stacked back-to-back, back-to-front, or front-to-front, and rotated 90 degrees) to a surface of a base IC die. Such vertically stacked IC packages may include memory IC dies, compute IC dies, or both memory and compute IC dies. Memory IC packages generally require 2 to 3 watt power delivery, so there is usually no large voltage droop, however, compute systems generally require 100 watt power delivery. In such compute systems, high efficiency power delivery is a major challenge and is critical to enable desired per watt performance. An IC package may include a voltage converter (VC) for adapting power delivery to an IC die. Integrating VCs into IC packages having vertically stacked IC dies may be difficult due to a limited footprint available in an IC package and an extended distance for delivering power to a vertically stacked IC dies, in particular, vertically stacked IC dies having power dense circuitry (e.g., central processing units (CPUs), graphic processing units (GPUs), and dedicated accelerators). Microelectronic assemblies disclosed herein may include topologies to deliver power to vertically stacked IC dies using voltage domain stacking. Various ones of the microelectronic assemblies disclosed herein may exhibit better power delivery and signal speed while reducing the complexity of the package relative to conventional approaches. In particular, various ones of the IC packages disclosed herein may enable vertically stacked and laterally coupled IC dies to be serially connected to a voltage converter enabling current input at the first IC die through subsequent serially connected IC dies and current output at the last IC die. More current is required for current input and current output, while less current is required for IC dies between the first and last IC dies as only differential current is required. Thus, current requirements for the IC package are reduced.

A microelectronic assembly disclosed herein may include an IC die coupled to a base IC die by interconnects on a first surface of the IC die and a second surface of the base IC die such that the first surface is in contact with the second surface, and the IC die includes a substrate attached to a metallization stack along an interface that is orthogonal to the first surface. The metallization stack of the IC die may include a plurality of layers of conductive traces in a dielectric material, and the interconnects may be coupled to the conductive traces exposed on the first surface. The IC die may include compute circuitry and VC circuitry integrated into the IC die that may be coupled to the surface of the base IC die. The base IC die may further include VC circuitry integrated in the base IC die. In some embodiments, the interconnects may include oxide-oxide bonds and metal-metal bonds, the metal-metal bonds including first bond-pads in the first IC dies and second bond-pads in the second IC die, where the first bond-pads include portions of the conductive traces exposed on the first surface.

Accordingly, IC dies and microelectronic assemblies, related devices and methods, are disclosed herein. In some embodiments, an integrated circuit (IC) die may include a substrate having a first surface, a second surface opposite the second surface, a third surface orthogonal to the first and second surfaces, and through substrate vias (TSVs) orthogonal to the first and second surfaces, the first surface having an array of first conductive pads electrically coupled to the TSVs; and a metallization stack having a fourth surface, a fifth surface opposite the fourth surface, and a sixth surface orthogonal to the fourth and fifth surfaces, the metallization stack including a conductive trace parallel to the fourth and fifth surfaces and exposed at the sixth surface, and conductive vias between the fourth and fifth surfaces and exposed at the fifth surface, wherein the second surface of the substrate is coupled to the fourth surface of the metallization stack, and an interface between the substrate and the metallization stack includes an array of second conductive pads electrically coupled to the conductive trace and conductive vias in the metallization stack. In some embodiments, a microelectronic assembly may include a plurality of first integrated circuit (IC) die having a substrate including a first surface having an array of first conductive pads and through substrate vias (TSVs) electrically coupled to the array of first conductive pads, the substrate including compute circuitry; and a metallization stack coupled to the substrate, wherein an interface between the substrate and the metallization stack is parallel to the first and second surfaces and includes an array of second conductive pads electrically coupled to the conductive vias, wherein the metallization stack includes conductive vias exposed at a second surface and a conductive trace exposed at a third surface orthogonal to the first and second surface, and wherein the plurality of first IC die are bonded together at respective first and second surfaces and conductive vias exposed at the second surface of one of the plurality of first IC die are electrically coupled to the array of first conductive pads at the first surface of an adjacent one of the plurality of first IC die; and a second IC die having a fourth surface, the second IC die including VC circuitry, wherein the conductive trace exposed at the third surface of the plurality of first IC dies is electrically coupled to the fourth surface of the second IC die.

Each of the structures, assemblies, packages, methods, devices, and systems of the present disclosure may have several innovative aspects, no single one of which is solely responsible for all the desirable attributes disclosed herein. Details of one or more implementations of the subject matter described in this specification are set forth in the description below and the accompanying drawings.

In the following detailed description, various aspects of the illustrative implementations may be described using terms commonly employed by those skilled in the art to convey the substance of their work to others skilled in the art.

The terms "circuit" and "circuitry" mean one or more passive and/or active electrical and/or electronic components that are arranged to cooperate with one another to provide a desired function. The terms also refer to analog circuitry, digital circuitry, hard wired circuitry, programmable circuitry, microcontroller circuitry and/or any other type of physical hardware electrical and/or electronic component.

The term "integrated circuit" means a circuit that is integrated into a monolithic semiconductor or analogous material.

In some embodiments, the IC dies disclosed herein may include substantially monocrystalline semiconductors, such as silicon or germanium, as a base material (e.g., substrate, body) on which integrated circuits are fabricated with traditional semiconductor processing methods. The semiconductor base material may include, for example, N-type pr P-type materials. Dies may include, for example, a crystalline base material formed using a bulk silicon (or other bulk semiconductor material) or a silicon-on-insulator (SOI) structure. In some other embodiments, the base material of one or more of the IC dies may include alternate materials, which may or may not be combined with silicon, that include but are not limited to germanium, indium antimonide, lead telluride, indium arsenide, indium phosphide, gallium arsenide, indium gallium arsenide, gallium antimonide, or other combinations of group III-N, group III-V, group II-VI, or group IV materials. In yet other embodiments, the base material may include compound semiconductors, for example, with a first sub-lattice of at least one element from group III of the periodic table (e.g., Al, Ga, In), and a second sub-lattice of at least one element of group V of the periodic table (e.g., P, As, Sb). In yet other embodiments, the base material may include an intrinsic IV or III-V semiconductor material or alloy, not intentionally doped with any electrically active impurity; in alternate embodiments, nominal impurity dopant levels may be present. In still other embodiments, dies may include a non-crystalline material, such as polymers; for example, the base material may include silica-filled epoxy. In other embodiments, the base material may include high mobility oxide semiconductor material, such as tin oxide, antimony oxide, indium oxide, indium tin oxide, titanium oxide, zinc oxide, indium zinc oxide, indium gallium zinc oxide (IGZO), gallium oxide, titanium oxynitride, ruthenium oxide, or tungsten oxide. In general, the base material may include one or more of tin oxide, cobalt oxide, copper oxide, antimony oxide, ruthenium oxide, tungsten oxide, zinc oxide, gallium oxide, titanium oxide, indium oxide, titanium oxynitride, indium tin oxide, indium zinc oxide, nickel oxide, niobium oxide, copper peroxide, IGZO, indium telluride, molybdenite, molybdenum diselenide, tungsten diselenide, tungsten disulfide, N- or P-type amorphous or polycrystalline silicon, germanium, indium gallium arsenide, silicon germanium, gallium nitride, aluminum gallium nitride, indium phosphide, and black phosphorus, each of which may possibly be doped with one or more of gallium, indium, aluminum, fluorine, boron, phosphorus, arsenic, nitrogen, tantalum, tungsten, and magnesium, etc. Although a few examples of the material for dies are described here, any material or structure that may serve as a foundation (e.g., base material) upon which IC circuits and structures as described herein may be built falls within the spirit and scope of the present disclosure.

Unless described otherwise, IC dies described herein include one or more IC structures (or, simply, "ICs") implementing (i.e., configured to perform) certain functionality. In one such example, the term "memory die" may be used to describe a die that includes one or more ICs implementing memory circuitry (e.g., ICs implementing one or more of memory devices, memory arrays, control logic configured to control the memory devices and arrays, etc.). In another such example, the term "compute die" may be used to describe a die that includes one or more ICs implementing logic/compute circuitry (e.g., ICs implementing one or more of I/O functions, arithmetic operations, pipelining of data, etc.).

In another example, the terms "package" and "IC package" are synonymous, as are the terms "die" and "IC die." Note that the terms "chip," "die," and "IC die" are used interchangeably herein.

The term "optical structure" includes arrangements of forms fabricated in ICs to receive, transform and/or transmit optical signals as described herein. It may include optical conductors such as waveguides, electromagnetic radiation sources such as lasers and light-emitting diodes (LEDs) and electro-optical devices such as photodetectors.

In various embodiments, any photonic IC (PIC) described herein may include a semiconductor material, for example, N-type or P-type materials. The PIC may include, for example, a crystalline base material formed using a bulk silicon (or other bulk semiconductor material) or a SOI structure (or, in general, a semiconductor-on-insulator structure). In some embodiments, the PIC may be formed using alternative materials, which may or may not be combined with silicon, that include, but are not limited to, lithium niobite, indium phosphide, silicon dioxide, germanium, silicon germanium, indium antimonide, lead telluride, indium arsenide, indium phosphide, gallium arsenide, aluminum gallium arsenide, aluminum arsenide, indium aluminum arsenide, aluminum indium antimonide, indium gallium arsenide, gallium nitride, indium gallium nitride, aluminum indium nitride or gallium antimonide, or other combinations of group III-N or group IV materials. In some embodiments, the PIC may include a non-crystalline material, such as polymers. In some embodiments, the PIC may be formed on a printed circuit board (PCB). In some embodiments, the PIC may be inhomogeneous, including a carrier material (such as glass or silicon carbide) as a base material with a thin semiconductor layer over which is an active side comprising transistors and like components. Although a few examples of the material for the PIC are described here, any material or structure that may serve as a foundation upon which the PIC may be built falls within the spirit and scope of the present disclosure.

The term "insulating" means "electrically insulating," the term "conducting" means "electrically conducting," unless otherwise specified. With reference to optical signals and/or devices, components and elements that operate on or using optical signals, the term "conducting" can also mean "optically conducting."

The terms "oxide," "carbide," "nitride," etc. refer to compounds containing, respectively, oxygen, carbon, nitrogen, etc.

The term "high-k dielectric" refers to a material having a higher dielectric constant than silicon oxide, while the term "low-k dielectric" refers to a material having a lower dielectric constant than silicon oxide.

The term "insulating material" or "insulator" (also called herein as "dielectric material" or "dielectric") refers to solid materials (and/or liquid materials that solidify after processing as described herein) that are substantially electrically nonconducting. They may include, as examples and not as limitations, organic polymers and plastics, and inorganic materials such as ionic crystals, porcelain, glass, silicon, silicon oxide, silicon carbide, silicon carbonitride, silicon nitride, and alumina or a combination thereof. They may include dielectric materials, high polarizability materials, and/or piezoelectric materials. They may be transparent or opaque without departing from the scope of the present disclosure. Further examples of insulating materials are underfills and molds or mold-like materials used in packaging applications, including for example, materials used in organic interposers, package supports and other such components.

In various embodiments, elements associated with an IC may include, for example, transistors, diodes, power sources, resistors, capacitors, inductors, sensors, transceivers, receivers, antennas, etc. In various embodiments, elements associated with an IC may include those that are monolithically integrated within an IC, mounted on an IC, or those connected to an IC. The ICs described herein may be either analog or digital and may be used in a number of applications, such as microprocessors, optoelectronics, logic blocks, audio amplifiers, etc., depending on the components associated with the IC. The ICs described herein may be employed in a single IC die or as part of a chipset for executing one or more related functions in a computer.

In various embodiments of the present disclosure, transistors described herein may be field-effect transistors (FETs), e.g., MOSFETs. In many embodiments, an FET is a four-terminal device. In silicon-on-insulator, or nanoribbon, or gate all-around (GAA) FET, the FET is a three-terminal device that includes source, drain, and gate terminals and uses electric field to control current flowing through the device. A FET typically includes a channel material, a source region and a drain regions provided in and/or over the channel material, and a gate stack that includes a gate electrode material, alternatively referred to as a "work function" material, provided over a portion of the channel material (the "channel portion") between the source and the drain regions, and optionally, also includes a gate dielectric material between the gate electrode material and the channel material.

In a general sense, an "interconnect" refers to any element that provides a physical connection between two other elements. For example, an electrical interconnect provides electrical connectivity between two electrical components, facilitating communication of electrical signals between them; an optical interconnect provides optical connectivity between two optical components, facilitating communication of optical signals between them. As used herein, both electrical interconnects and optical interconnects are included in the term "interconnect." The nature of the interconnect being described is to be understood herein with reference to the signal medium associated therewith. Thus, when used with reference to an electronic device, such as an IC that operates using electrical signals, the term "interconnect" describes any element formed of an electrically conductive material for providing electrical connectivity to one or more elements associated with the IC or/and between various such elements. In such cases, the term "interconnect" may refer to both conductive traces (also sometimes referred to as "lines," "wires," "metal lines" or "trenches") and conductive vias (also sometimes referred to as "vias" or "metal vias"). Sometimes, electrically conductive traces and vias may be referred to as "conductive traces" and "conductive vias", respectively, to highlight the fact that these elements include electrically conductive materials such as metals. Likewise, when used with reference to a device that operates on optical signals as well, such as a PIC, "interconnect" may also describe any element formed of a material that is optically conductive for providing optical connectivity to one or more elements associated with the PIC. In such cases, the term "interconnect" may refer to optical waveguides, including optical fiber, optical splitters, optical combiners, optical couplers, and optical vias.

The term "waveguide" refers to any structure that acts to guide the propagation of light from one location to another location typically through a substrate material such as silicon or glass. In various examples, waveguides can be formed from silicon, doped silicon, silicon nitride, glasses such as silica (e.g., silicon dioxide or SiO₂), borosilicate (e.g., 70-80 wt% SiO₂, 7-13 wt% of B₂O₃, 4-8 wt% Na₂O or K₂O, and 2-8 wt% of Al₂O₃) and so forth. Waveguides may be formed using various techniques including but not limited to forming waveguides in situ. For example, in some embodiments, waveguides may be formed in situ in glass using low temperature glass-to-glass bonding or by laser direct writing. Waveguides formed in situ may have lower loss characteristics.

The term "conductive trace" may be used to describe an electrically conductive element isolated by an insulating material. Within IC dies, such insulating material comprises interlayer low-k dielectric that is provided within the IC die. Within package substrates, and PCBs such insulating material includes organic materials such as Ajinomoto Buildup Film (ABF), polyimides, or epoxy resin. Such conductive lines are typically arranged in several levels, or several layers, of metallization stacks.

The term "conductive via" may be used to describe an electrically conductive element that interconnects two or more conductive lines of different levels of a metallization stack. To that end, a via may be provided substantially perpendicularly to the plane of an IC die/chip or a support structure over which an IC structure is provided and may interconnect two conductive lines in adjacent levels or two conductive lines in non-adjacent levels.

The term "package substrate" may be used to describe any substrate material that facilitates the packaging together of any collection of semiconductor dies and/or other electrical components such as passive electrical components. As used herein, a package substrate may be formed of any material including, but not limited to, insulating materials such as resin impregnated glass fibers (e.g., PCB or Printed Wiring Boards (PWB)), glass, ceramic, silicon, silicon carbide, etc. In addition, as used herein, a package substrate may refer to a substrate that includes buildup layers (e.g., ABF layers).

The term "metallization stack" may be used to refer to a stack of one or more interconnects for providing connectivity to different circuit components of an IC die/chip and/or a package substrate.

As used herein, the term "pitch" of interconnects refers to a center-to-center distance between adjacent interconnects.

It will be recognized that one more levels of underfill (e.g., organic polymer material such as benzotriazole, imidazole, polyimide, or epoxy) may be provided in an IC package described herein and may not be labeled in order to avoid cluttering the drawings. In various embodiments, the levels of underfill may include the same or different insulating materials. In some embodiments, the levels of underfill may include thermoset epoxies with silicon oxide particles; in some embodiments, the levels of underfill may include any suitable material that can perform underfill functions such as supporting the dies and reducing thermal stress on interconnects. In some embodiments, the choice of underfill material may be based on design considerations, such as form factor, size, stress, operating conditions, etc.; in other embodiments, the choice of underfill material may be based on material properties and processing conditions, such as cure temperature, glass transition temperature, viscosity and chemical resistance, among other factors; in some embodiments, the choice of underfill material may be based on both design and processing considerations.

In some embodiments, one or more levels of solder resist (e.g., epoxy liquid, liquid photoimageable polymers, dry film photoimageable polymers, acrylics, solvents) may be provided in an IC package described herein and may not be labeled or shown to avoid cluttering the drawings. Solder resist may be a liquid or dry film material including photoimageable polymers. In some embodiments, solder resist may be non-photoimageable.

The terms "substantially," "close," "approximately," "near," and "about," generally refer to being within +/- 20% of a target value (e.g., within +/- 5% or 10% of a target value) based on the context of a particular value as described herein or as known in the art.

Terms indicating orientation of various elements, e.g., "coplanar," "perpendicular," "orthogonal," "parallel," or any other angle between the elements, generally refer to being within +/-5%-20% of a target value based on the context of a particular value as described herein or as known in the art.

The term "connected" means a direct connection (which may be one or more of a mechanical, electrical, and/or thermal connection) between the things that are connected, without any intermediary devices, while the term "coupled" means either a direct connection between the things that are connected, or an indirect connection through one or more passive or active intermediary devices.

The description uses the phrases "in an embodiment" or "in embodiments," which may each refer to one or more of the same or different embodiments.

Furthermore, the terms "comprising," "including," "having," and the like, as used with respect to embodiments of the present disclosure, are synonymous.

The disclosure may use perspective-based descriptions such as "above," "below," "top," "bottom," and "side"; such descriptions are used to facilitate the discussion and are not intended to restrict the application of disclosed embodiments.

The terms "over," "under," "between," and "on" as used herein refer to a relative position of one material layer or component with respect to other layers or components. For example, one layer disposed over or under another layer may be directly in contact with the other layer or may have one or more intervening layers. Moreover, one layer disposed between two layers may be directly in contact with one or both of the two layers or may have one or more intervening layers. In contrast, a first layer described to be "on" a second layer refers to a layer that is in direct contact with that second layer. Similarly, unless explicitly stated otherwise, one feature disposed between two features may be in direct contact with the adjacent features or may have one or more intervening layers.

The term "dispose" as used herein refers to position, location, placement, and/or arrangement rather than to any particular method of formation.

The term "between," when used with reference to measurement ranges, is inclusive of the ends of the measurement ranges.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C). When used herein, the notation "A/B/C" means (A), (B), and/or (C).

Although certain elements may be referred to in the singular herein, such elements may include multiple sub-elements. For example," an electrically conductive material" may include one or more electrically conductive materials. In another example, "a dielectric material" may include one or more dielectric materials.

Unless otherwise specified, the use of the ordinal adjectives "first," "second," and "third," etc., to describe a common object, merely indicate that different instances of like objects are being referred to, and are not intended to imply that the objects so described must be in a given sequence, either temporally, spatially, in ranking or in any other manner.

In the following detailed description, reference is made to the accompanying drawings that form a part hereof, and in which is shown, by way of illustration, embodiments that may be practiced. It is to be understood that other embodiments may be utilized, and structural or logical changes may be made without departing from the scope of the present disclosure. Therefore, the following detailed description is not to be taken in a limiting sense.

The accompanying drawings are not necessarily drawn to scale.

In the drawings, same reference numerals refer to the same or analogous elements/materials shown so that, unless stated otherwise, explanations of an element/material with a given reference numeral provided in context of one of the drawings are applicable to other drawings where element/materials with the same reference numerals may be illustrated. Further, the singular and plural forms of the labels may be used with reference numerals to denote a single one and multiple ones respectively of the same or analogous type, species, or class of element.

Furthermore, in the drawings, some schematic illustrations of example structures of various devices and assemblies described herein may be shown with precise right angles and straight lines, but it is to be understood that such schematic illustrations may not reflect real-life process limitations which may cause the features to not look so "ideal" when any of the structures described herein are examined using, e.g., images of suitable characterization tools such as scanning electron microscopy (SEM) images, transmission electron microscope (TEM) images, or non-contact profilometer. In such images of real structures, possible processing and/or surface defects could also be visible, e.g., surface roughness, curvature or profile deviation, pit or scratches, not-perfectly straight edges of materials, tapered vias or other openings, inadvertent rounding of corners or variations in thicknesses of different material layers, occasional screw, edge, or combination dislocations within the crystalline region(s), and/or occasional dislocation defects of single atoms or clusters of atoms. There may be other defects not listed here but that are common within the field of device fabrication and/or packaging.

Note that in the figures, various components (e.g., interconnects) are shown as aligned (e.g., at respective interfaces) merely for ease of illustration; in actuality, some or all of them may be misaligned. In addition, there may be other components, such as bond-pads, landing pads, metallization, etc. present in the assembly that are not shown in the figures to prevent cluttering. Further, the figures are intended to show relative arrangements of the components within their assemblies, and, in general, such assemblies may include other components that are not illustrated (e.g., various interfacial layers or various other components related to optical functionality, electrical connectivity, or thermal mitigation). For example, in some further embodiments, the assembly as shown in the figures may include more dies along with other electrical components. Additionally, although some components of the assemblies are illustrated in the figures as being planar rectangles or formed of rectangular solids, this is simply for ease of illustration, and embodiments of these assemblies may be curved, rounded, or otherwise irregularly shaped as dictated by and sometimes inevitable due to the manufacturing processes used to fabricate various components.

In the drawings, a particular number and arrangement of structures and components are presented for illustrative purposes and any desired number or arrangement of such structures and components may be present in various embodiments.

Further, unless otherwise specified, the structures shown in the figures may take any suitable form or shape according to material properties, fabrication processes, and operating conditions.

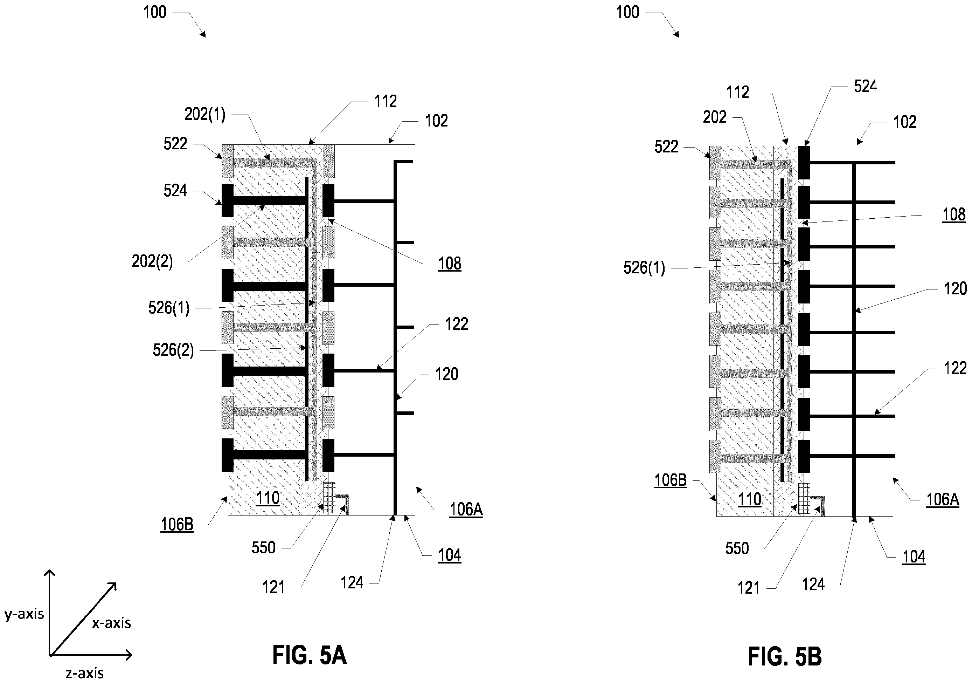

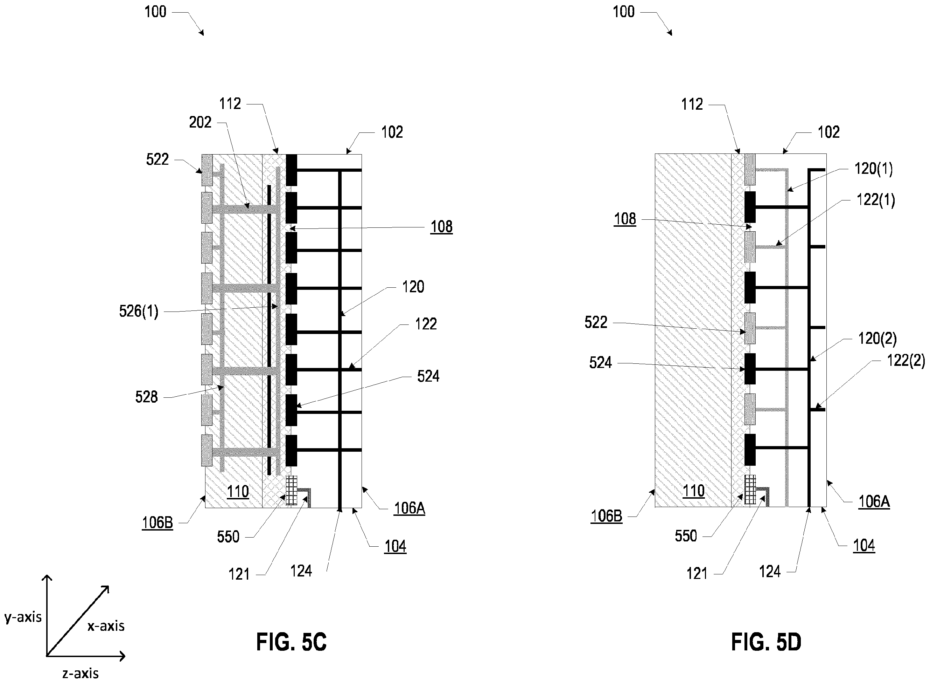

For convenience, if a collection of drawings designated with different letters are present (e.g., FIGS. 5A and 5B), such a collection may be referred to herein without the letters (e.g., as "FIG. 5"). Similarly, if a collection of reference numerals designated with different letters are present (e.g., 100(1), 100(2), 100(3)), such a collection may be referred to herein without the letters (e.g., as "100").

Various operations may be described as multiple discrete actions or operations in turn in a manner that is most helpful in understanding the claimed subject matter. However, the order of description should not be construed as to imply that these operations are necessarily order dependent. In particular, these operations may not be performed in the order of presentation. Operations described may be performed in a different order from the described embodiment. Various additional operations may be performed, and/or described operations may be omitted in additional embodiments.

### Example embodiments

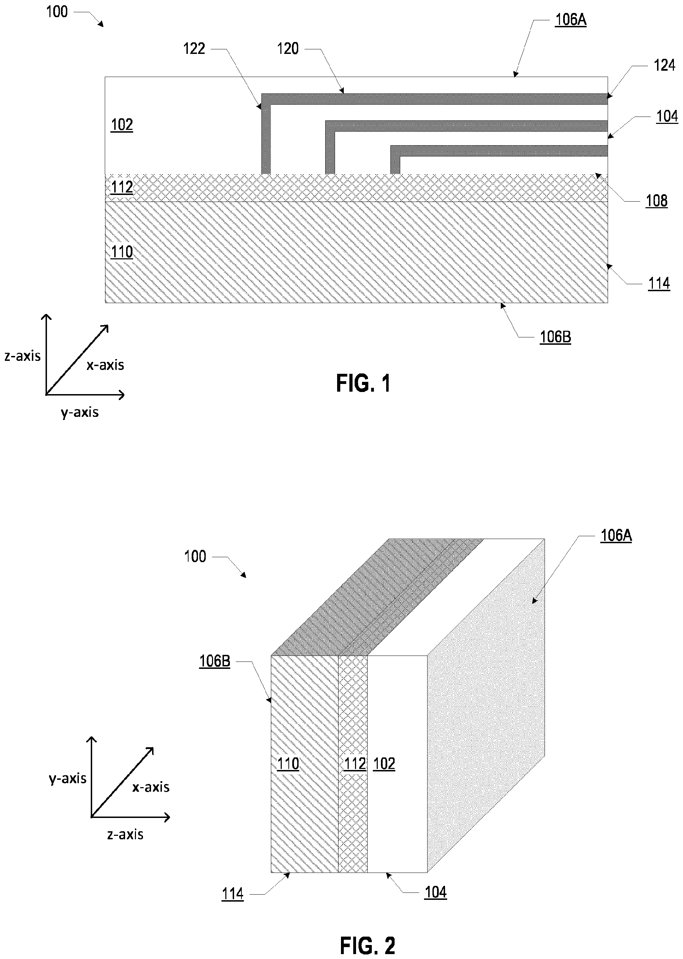

FIG. 1 is a schematic cross-sectional view of an example IC die 100 according to some embodiments of the present disclosure. IC die 100 includes, in the embodiment shown, a metallization stack 102 having a surface 104 orthogonal to surfaces 106A, 106B. In various embodiments, surfaces 104 and 106, particularly surface 106A, may be planarized. Generally, an IC die, that is different from IC die 100, does not have planarized edges along the thickness, e.g., the vertical surfaces corresponding to surface 104 would be rough, having undergone a dicing operation when the IC die is singulated from a wafer. In contrast, surface 104 of IC die 100 may be flat and planar with surface roughness less than 10 Angstroms and total thickness variation (TTV) across surface 104 of less than 3 microns.

Metallization stack 102 may be on a substrate 110 (e.g., at an interface 108). Interface 108 may be orthogonal to surface 104 and parallel to surface 106 (e.g., in the xy-plane). It is to be understood that while the interface 108 is in the xy-plane, the interface 108 may not be exactly planar. The substrate 110 may further include active region 112. In some embodiments, active region 112 may include transistors, diodes, and other active circuitry and may be proximate to interface 108. In some other embodiments, active region 112 may be absent, or alternatively, transistors, diodes, and other active circuitry may be absent in active region 112. Substrate 110 may have a surface 114 that may be coplanar with surface 104. In some embodiments, substrate 110 may include a semiconductor material as listed above in the previous subsection. In other embodiments, substrate 110 may include glass, ceramic, or other materials that may be suitable for creating functional elements of an IC.

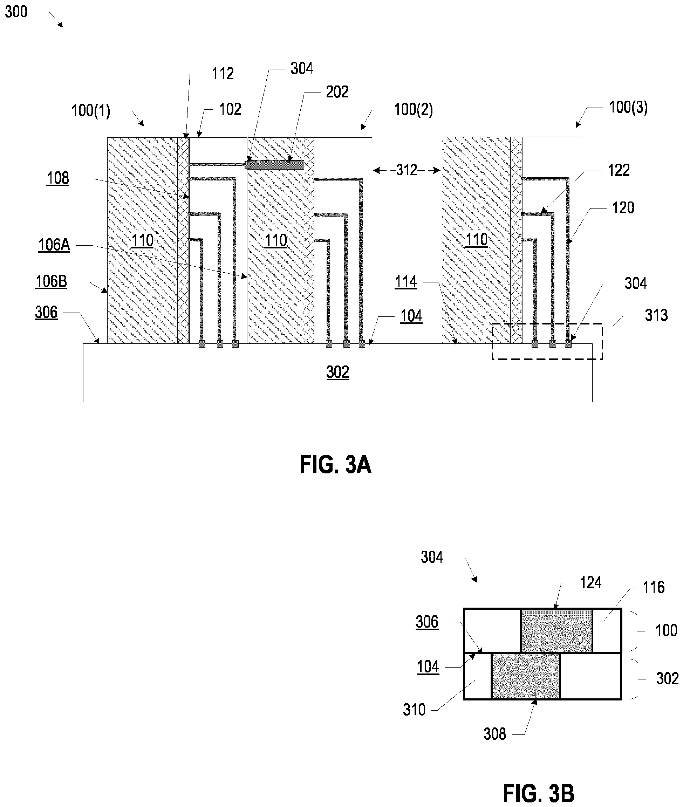

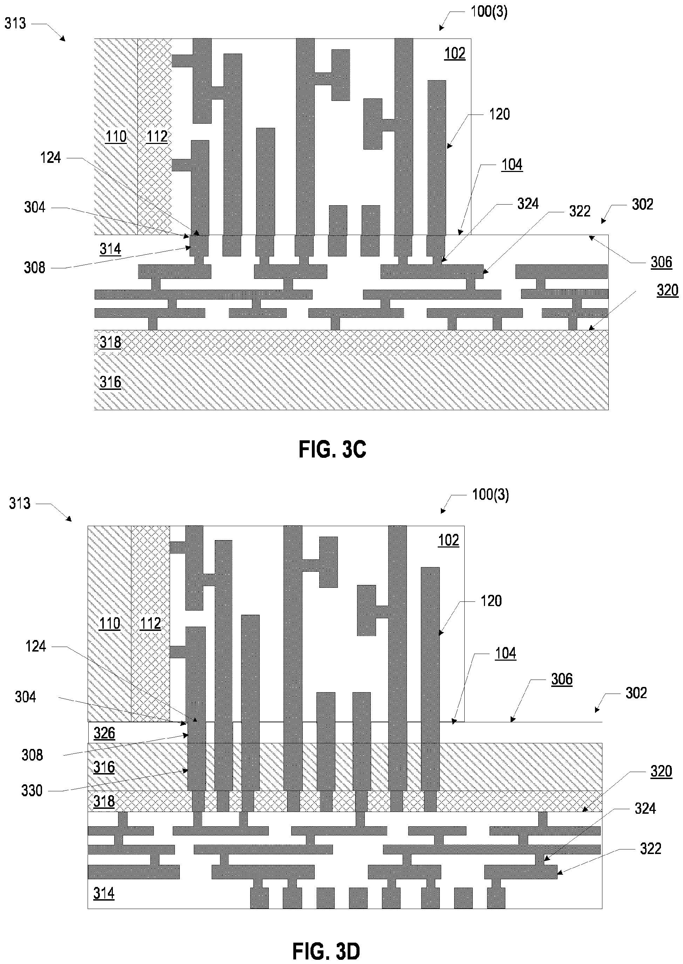

In various embodiments, metallization stack 102 may include a dielectric material, or a plurality of layers of dielectric material, and conductive pathways (e.g., conductive traces 120 and conductive vias 122) through the dielectric material. The conductive traces 120 may be parallel to surface 106 such that conductive traces 120 are orthogonal to surface 104. In some embodiments, a dielectric material of the metallization stack 102 may include silicon oxide; in other embodiments, the dielectric material of the metallization stack 102 may include any suitable dielectric material used as interlayer dielectrics (ILD) in a typical semiconductor IC die and as described above in the previous subsection. Conductive traces 120 may include a conductive metal, such as copper, in many embodiments. In some embodiments, there may be between 2 and 6 layers of conductive traces 120 in the plurality of layers of dielectric material. Conductive vias 122 through the dielectric material may conductively connect conductive traces 120 to active circuitry in active region 112. Conductive vias 122 are orthogonal to conductive traces 120. Conductive traces 120 may extend up to surface 104 such that portions of conductive traces 120 are exposed on surface 104; such exposed portions may form bonding-portions 124. In various embodiments, there may be several conductive traces 120 between interface 108 and surface 106A. One or more of the conductive traces 120 may be exposed on surface 104 as bonding-portions 124. In some embodiments, a cross-section linear dimension (e.g., thickness (z-dimension), width (x-dimension), or diagonal) of the largest bonding-portion 124 may be less than 10 microns or may be less than 5 microns. In some embodiments, bonding-portions 124 may be spaced apart with a pitch of less than 9 microns. In some embodiments, a bond-pad (e.g., similar to conductive bond-pad 308, as shown in FIG. 3) may be formed on a bonding-portion 124 at the surface 104. Conductive traces 120 may have any suitable dimensions. For example, conductive traces 120 may have a cross-section linear dimension between 1 micron and 10 microns. In some embodiments, some conductive traces 120 may be configured to route signals. In such embodiments, conductive traces 120 may be thinner (e.g., having a cross-section linear dimension between 1 micron and 5 microns). In some embodiments, some conductive traces 120 may be configured to route power and ground to active region 112. In such embodiments, conductive traces 120 may be thicker (e.g., having a cross-section linear dimension between 3 microns and 10 microns). In other embodiments, conductive traces 120 may be configured to route signals, power, and ground without any differentiation between them. In such embodiments, conductive traces 120 may have similar cross-section linear dimensions.

FIG. 2 is a simplified perspective view of an IC die 100. FIG. 2 shows IC die 100 of FIG. 1 that has been rotated 90 degrees so that the surfaces 114 and 104 are positioned at the bottom and the surfaces 106A, 106B are positioned laterally. IC die 100 may include substrate 110, active region 112, and metallization stack 102. IC die 100 may have any suitable dimensions. In various embodiments, IC die 100 may have a thickness (e.g., z-dimension) between 10 microns and 800 microns (e.g., between 10 microns and 100 microns), a width (e.g., y-dimension) between 1 millimeter and 6 millimeters, and a length (e.g., x-dimension) between 10 millimeters and 33 millimeters. Substrate 110 of IC die 100 may be thinned so that IC die 100 has a desired thickness. Substrate 110 may have any suitable thickness (e.g., z-dimension). For example, substrate 110 may have a thickness between less than 1 micron and 50 microns (e.g., between 0.25 microns and 5 microns, or between 20 microns and 50 microns). In some embodiments, substrate 110 may further include through-substrate vias (TSVs) 202 (e.g., as shown in FIG. 3A and FIGS. 5A-5C) that enable conductive pathways between conductive traces 120 and/or active region 112 of an IC die and conductive traces 120 and/or active region 112 of an adjacent IC die. In some embodiments, TSVs 202 may be through active region 112. In some embodiments, substrate 110 may be almost entirely removed such that TSVs 202 (not shown) may be very thin (e.g., having a thickness of less than 1 micron) and may provide direct contact to a transistor source/drain in active region 112.

FIGS. 3A-3D show simplified schematic cross-sections of various configurations of a microelectronic assembly 300 according to embodiments of the present disclosure. FIG. 3A shows microelectronic assembly 300 comprising a plurality of IC dies 100, for example, 100(1), 100(2) and 100(3) coupled to another IC die 302 by interconnects 304 such that surface 104 of any one of IC dies 100 is in direct contact with a surface 306 of IC die 302. As described in relation to FIGS. 1 and 2, surface 104 is orthogonal to interface 108 between active region 112 and metallization stack 102 of any one of IC dies 100. In some embodiments, IC dies 100 may include active circuitry (e.g., transistors, diodes) in active region 112. In other embodiments, one or more IC dies 100 may not include active circuitry in active region 112; in such embodiments, active region 112 may be merged with substrate 110 (e.g., absent).

In various embodiments, IC die 302 may include an interposer with conductive traces to enable conductive coupling of IC die 100 with other IC dies and/or package substrates, and IC die 302 may not have any active circuitry therein. In other embodiments, IC die 302 may include active circuitry. In many embodiments, IC dies 100 may be conductively coupled by conductive pathways in IC die 302. For example, IC die 302 may include a network on chip, interconnecting compute circuitry of IC dies 100 together. In various embodiments, IC die 100 may be conductively coupled to IC die 302 by interconnects 304, which may include hybrid bonds. In such configuration, surface 114 of substrate 110 of IC dies 100 may be in direct contact with surface 306 of IC die 302.

FIG. 3B is a schematic cross-sectional view of a detail of a particular one of interconnects 304 in microelectronic assembly 300. Note that although only interconnect 304 is shown, the same structure and description may apply to any other such interconnects comprising hybrid bonds in microelectronic assembly 300. In a general sense, interconnect 304 may include, at an interface between surface 104 of IC die 100 and surface 306 of IC die 302, metal-metal bonds between bonding-portions 124 of IC die 100 and bond-pads 308 of IC die 302, and dielectric-dielectric bonds (e.g., oxide-oxide bonds) in dielectric materials 116 and 310 of IC dies 100 and 302, respectively. Bonding-portions 124 belonging to IC die 100 may bond with bond-pads 308 of IC die 302. As noted in the description of FIG. 1, bonding-portions 124 may include a portion of conductive traces 120 exposed on surface 104; bond-pads 308 may include conventional conductive structures electroplated on surface 306. Dielectric material 116 (e.g., silicon oxide, silicon nitride, silicon oxynitride, etc.) in IC die 100 may bond with a dielectric material 310 in IC die 302. In some embodiments, dielectric material 310 of IC die 302 is the same as dielectric material 116 of IC die 100. In various embodiments, dielectric material 310 includes silicon oxide, silicon nitride, silicon carbonitride, and other such inorganic materials commonly used to fabricate semiconductor IC dies. The bonded metal and dielectric materials form interconnect 304, comprising hybrid bonds, providing electrical and mechanical coupling between IC die 100 and IC die 302. In various embodiments, interconnects 304 may have a linear dimension of less than 5 microns and a pitch of less than 10 microns between adjacent interconnects.

Turning back to FIG. 3A, IC dies 100 may be coupled to IC die 302 such that metallization stack 102 of one of IC dies 100, for example, 100(1), may be in direct contact with substrate 110 of adjacent IC die 100, for example, 100(2). In such embodiments, IC dies 100(1) and 100(2) may be bonded to each other, at least by oxide-oxide bonds. In some embodiments, interconnects 304, comprising metal-metal bonds and oxide-oxide bonds as described in reference to FIG. 3B, may be present at the planar contact interface between IC dies 100(1) and 100(2). In some such embodiments, conductive contact between active region 112 of IC die 100(1) and 100(2) may be achieved through conductive traces 120 in IC die 100(1), interconnects 304 at the interface between IC dies 100(1) and 100(2), and TSVs 202 in IC die 100(2); in such embodiments, TSVs 202 are in conductive contact with interconnects 304 between IC dies 100(1) and 100(2). In other embodiments (not shown), metallization stack 102 of IC dies 100(1) and 100(2) may be in contact in a front-to-front configuration. In yet other embodiments (not shown), substrate 110 of IC dies 100(1) and 100(2) may be in contact in a back-to-back configuration.

In various embodiments, IC dies 100 may be arranged in mutually parallel rows such that a gap 312 exists between adjacent IC dies 100. Gap 312 may be uniform across microelectronic assembly 300 in some embodiments and may range approximately in the order of a few millimeters (e.g., less than 5 millimeters); in other embodiments, gap 312 may be non-uniform, with some IC dies 100 being closer to other than other IC dies 100. In some such embodiments, IC dies 100 may include circuitry that consumes electrical power and generates heat during operation. For example, IC dies 100 may include compute circuitry of a microprocessor. Gap 312 may be configured for flow of a cooling fluid therethrough. The cooling fluid (not shown) may be air in some embodiments; in other embodiments, the cooling fluid may be a liquid coolant.

In some embodiments, IC dies 100 may include compute circuitry and VC circuitry, and IC die 302 may include a network on chip circuitry, conductively coupling the array of IC dies 100. In some embodiments, IC dies 100(1), 100(2) may include memory circuitry, IC die 100(3) may include compute circuitry and VC circuitry, and IC die 302 may include a network on chip circuitry, conductively coupling the array of IC dies 100. In some embodiments, IC die 100(1) may include capacitors and/or inductors, IC die 100(2) may include compute circuitry and VC circuitry, IC die 100(3) may include memory circuitry, and IC die 302 may include a network on chip circuitry, conductively coupling the array of IC dies 100. In other embodiments, some IC dies 100 may include graphics processing circuitry and other IC dies may include compute circuitry and VC circuitry, and IC die 302 may include VC circuitry. Any suitable configuration of circuitry may be provided in microelectronic assembly 300 among IC dies 100 and IC die 302 as desired and based on particular needs.

FIG. 3C is a schematic cross-sectional view of a portion 313 of microelectronic assembly 300 of FIG. 3A according to some embodiments of the present disclosure. IC die 302 may include a metallization stack 314 attached to a substrate 316 having an active region 318. Substrate 316 is attached to metallization stack 314 along another interface 320 that is parallel to surface 306. In some embodiments, active region 318 includes active circuitry (not shown), including transistors and diodes. Active region 318 may be proximate to interface 320 in such embodiments. In some embodiments, active region 318 may be absent. Metallization stack 314 may further include conductive pathways (e.g., conductive traces 322 and conductive vias 324) in a dielectric material. In some embodiments, the dielectric material of metallization stack 314 is the dielectric material 310 in FIG. 3B. Conductive traces 322 may be coupled by conductive vias 324 to bond-pads 308.

FIG. 3D is a schematic cross-sectional view of portion 313 of microelectronic assembly 300 of FIG. 3A according to some embodiments of the present disclosure. IC die 302 may be substantially similar to the embodiment of FIG. 3C, except that it is inverted (e.g., turned upside-down), so that substrate 316 is proximate to surface 104 of IC die 100. In such embodiments, IC die 302 may include an interface layer 326 (e.g., bonding layer) on a side of substrate 316 opposite to metallization stack 314. Interface layer 326 includes bond-pads 308 having a dielectric material between bond-pads 308 (e.g., surrounding the bond-pads 308), such that interconnects 304 are formed from metal-metal bonds of bonding-portions 124 and bond-pads 308 and oxide-oxide bonds of dielectric materials of the substrate 110 of IC die 100(3) and of the interface layer 326 of IC die 302. In some embodiments, the dielectric material of the interface layer 326 is a same material as the dielectric material 310 in FIG. 3B. In some embodiments, dielectric material of the interface layer 326 is a same material as the dielectric material 116 of IC die 100 in FIG. 3B. In various embodiments, the dielectric material of the interface layer 326 may include silicon oxide, silicon nitride, silicon carbonitride, or other such inorganic materials commonly used to fabricate semiconductor IC dies. In such embodiments, IC die 302 may further include TSVs 330 in substrate 316 between interface layer 326 and metallization stack 314. TSVs 330 may enable electrical connectivity between interconnects 304 and active region 318 and/or conductive traces 322 in IC die 302.

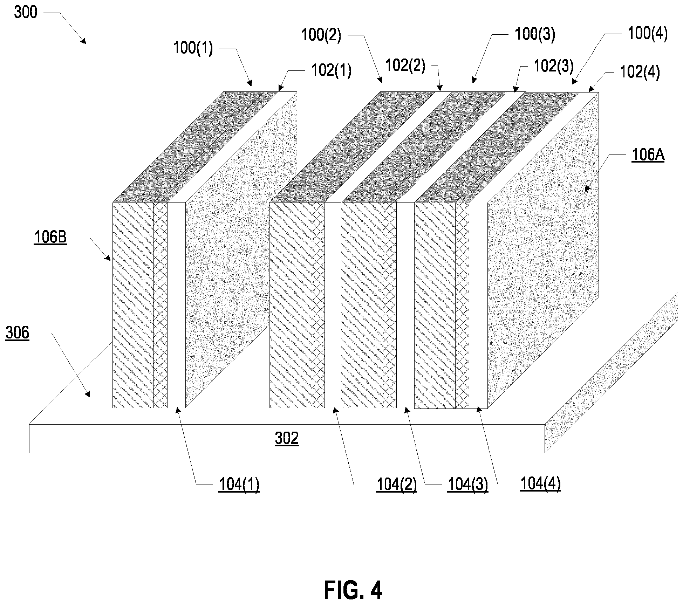

FIG. 4 is a simplified perspective view of an example microelectronic assembly 300 including IC dies 100 of FIG. 2. Note that for ease of illustration, and so as not to clutter the drawings, the figure is not drawn to scale, nor are detailed features shown. A plurality of IC dies 100 (e.g., IC dies 100(1), 100(2), 100(3), and 100(4)) may be coupled at respective surfaces 104 (e.g., surfaces 104(1), 104(2), 104(3), and 104(4)) with surface 306 of IC die 302. The plurality of IC dies 100 may be coupled to IC die 302 by any suitable interconnects, for example, interconnects 304 in FIG. 3. In many embodiments, IC die 302 may be large-sized, for example, as large as a conventional reticle, which can be approximately 850 square millimeters in footprint area. Although FIG. 4 shows IC dies 100 having metallization stacks 102(1), 102(2), 102(3), 102(4) facing away from each other, in some embodiments, one or more of IC dies 100 may have one or more metallization stacks 102 facing each other. As shown in FIG. 4, IC dies 100(2), 100(3), and 100(4) may be stacked vertically and bonded together, for example, by oxide-oxide bond or inorganic dielectric-inorganic dielectric bonds. The stacked and bonded IC dies 100 may be rotated 90 degrees and electrically coupled to IC die 302. The plurality of IC dies 100 may be coupled to IC die 302 by any suitable interconnects, for example, interconnects 304 in FIG. 3. Stacking and bonding IC dies 100 prior to coupling with IC die 302 may allow for IC dies 100 to be more easily handled during assembly operations. Any suitable number of IC dies 100 may be stacked and bonded together, for example, between 2 and 100 IC dies. Although FIG. 4 shows IC dies 100 having a particular stacked arrangement (e.g., all facing a same direction), in some embodiments, one or more of IC dies 100 may have a different stacked arrangement (e.g., one or more IC dies 100 may be inverted to face an opposite direction).

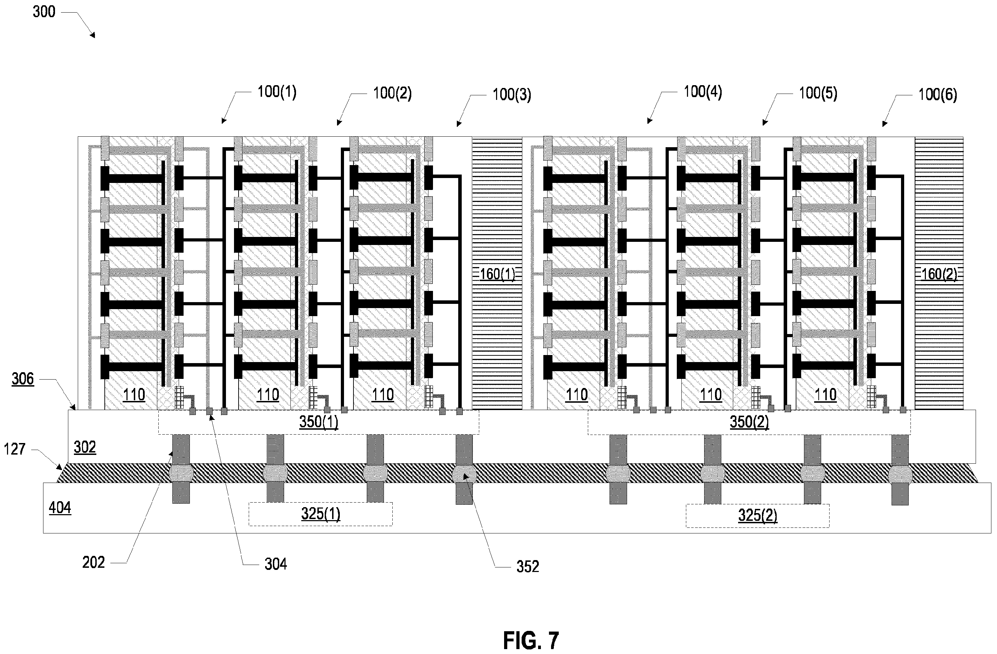

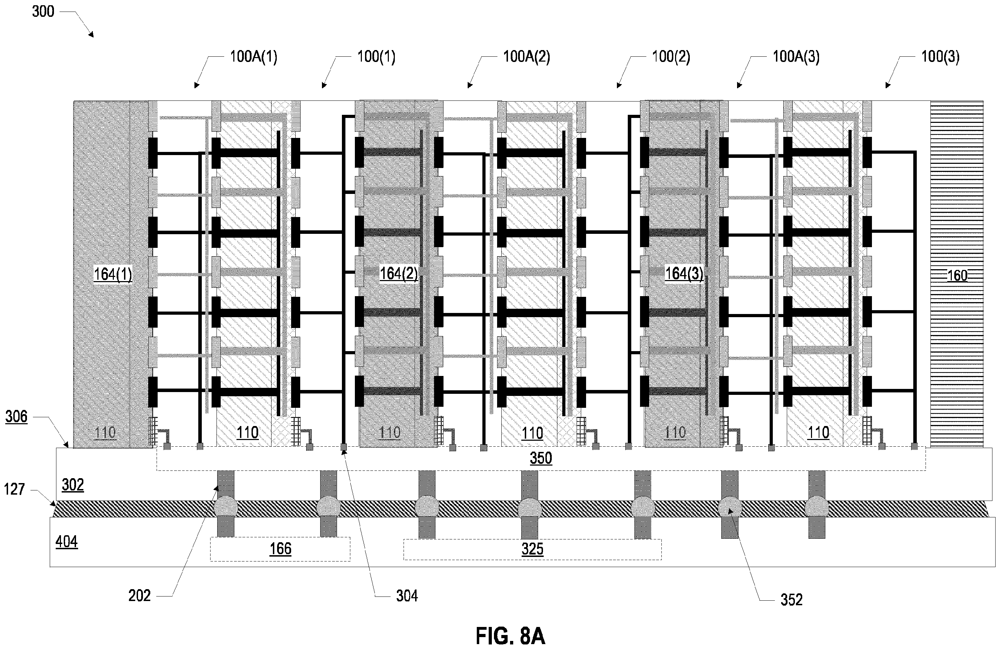

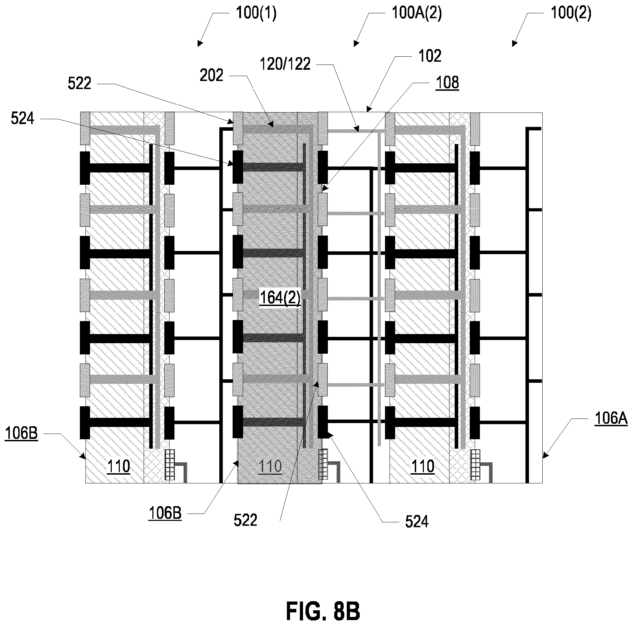

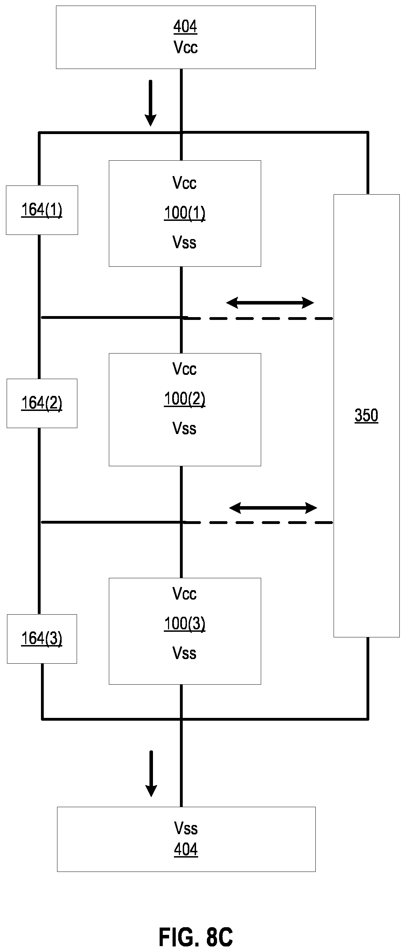

FIG. 5A is a schematic cross-sectional view of an example IC die 100 according to some embodiments of the present disclosure. The embodiment shown in the figure is similar to that of FIG. 1, except that additional details of a voltage domain are shown, including Vcc pads 522, Vss pads 524, input pad 550 (e.g., a signal input), and associated conductive pathways 120, 121, 122, 202, 526. As used herein, the term "Vcc" refers to the positive power supply voltage, and the term "Vss" refers to the ground or zero voltage connection point. By connecting the power domains serially (e.g., as shown in FIGS. 7 and 8), the input voltage of the aggregate domains is increased while the input current is reduced to a single domain rather than a sum of all domains (e.g., VC circuitry balances current across the individual domains and only needs to deliver differential current amounts to the individual domains). In some embodiments, a TSV 202 may include a conductive via that electrically couples one surface 106B of the substrate 110 to an opposite surface of the substrate 110 (e.g., a conductive via that extends from surface 106B through substrate 110 and active region 112 to interface 108). In some embodiments, as shown in FIG. 5A, 5B, and 5C, a TSV 202 may include a conductive via that extends from surface 106B of substrate 110 to metal layers 526 in active region 112 and does not extend to interface 108 (e.g., a conductive via that extends partially through substrate 110, such that surface 106B is coupled to interface 108 by TSV 202 and metal layers 526, and, optionally, by other conductive pathways in substrate 110). As described in relation to FIGS. 1 and 2, surface 104 is orthogonal to interface 108 between active region 112 and metallization stack 102 of IC die 100. In some embodiments, IC die 100 may include active circuitry (e.g., transistors, diodes) in active region 112. In some embodiments, IC die 100 may include VC circuitry. Input pad 550 may be electrically coupled to circuitry in IC die 100 by conductive pathway 121.

As shown in FIG. 5A, IC die 100 may include an array of Vcc pads 522 and Vss pads 524 at surface 106B of substrate 110 and at interface 108 (e.g., between active region 112 and metallization stack 102). The array of Vcc pads 522 and Vss pads 524 may include alternating rows of Vcc pads 522 and Vss pads 524. Some of the TSVs 202 may electrically couple individual ones of the array of Vcc pads 522 at surface 106B to individual ones of the array of Vcc pads 522 at interface 108 and some of the TSVs 202 may electrically couple individual ones of the array of Vss pads 524 at surface 106B to individual ones of the array of Vss pads 522 at interface 108. As described above, a TSV 202 may extend from surface 106B to interface 108 or TSV 202 may be coupled to one or more metal layers (e.g., metal layer 526 in FIG. 5A and/or metal layer 528 in FIG. 5C). Voltage domains of bonded IC die 100 (e.g., as shown in FIGS. 3 and 4) may be connected in series (e.g., serially connected, where Vss pad 524 at interface 108 of a first IC die 100 is connected to Vcc pad 522 at surface 106B of an adjacent second IC die 100 by conductive pathways 120 and conductive vias 122 through metallization stack 102 and exposed at surface 106A). Vcc pads 522 at surface 106B of substrate 110 may be electrically coupled to metal layers 526(1) and p-type devices in the active region 112 by TSVs 202(1) through substrate 110 and to Vcc pads 522 at interface 108. Vss pads 524 at surface 106B may be electrically coupled to metal layers 526(2) and n-type devices in the active region 112 by TSVs 202(2) through substrate 110 and to Vss pads 524 at interface 108.

FIG. 5B is a schematic cross-sectional view of an example IC die 100 according to some embodiments of the present disclosure. The embodiment shown in the figure is similar to that of FIG. 5A, except that IC die 100 includes an array of Vcc pads 522 at surface 106B and an array of Vss pads 524 at interface 108. The array of Vcc pads 522 at surface 106B may be electrically coupled to metal layers 526(1) and devices in the active region 112 by TSVs 202. The array of Vss pads 524 at interface 108 may be electrically coupled to Vcc pads 522 at a surface 106B of an adjacent IC die 100 by conductive pathways 120 and conductive vias 122 through metallization stack 102 and exposed at surface 106A.

FIG. 5C is a schematic cross-sectional view of an example IC die 100 according to some embodiments of the present disclosure. The embodiment shown in the figure is similar to that of FIG. 5B, except that IC die 100 includes a metallization layer 528 adjacent to surface 106B in substrate 110 that aggregates individual Vcc pads 522 in the array of Vcc pads 522 to reduce the number TSVs 202 that couple to metal layers 526(1) and devices in the active region 112.

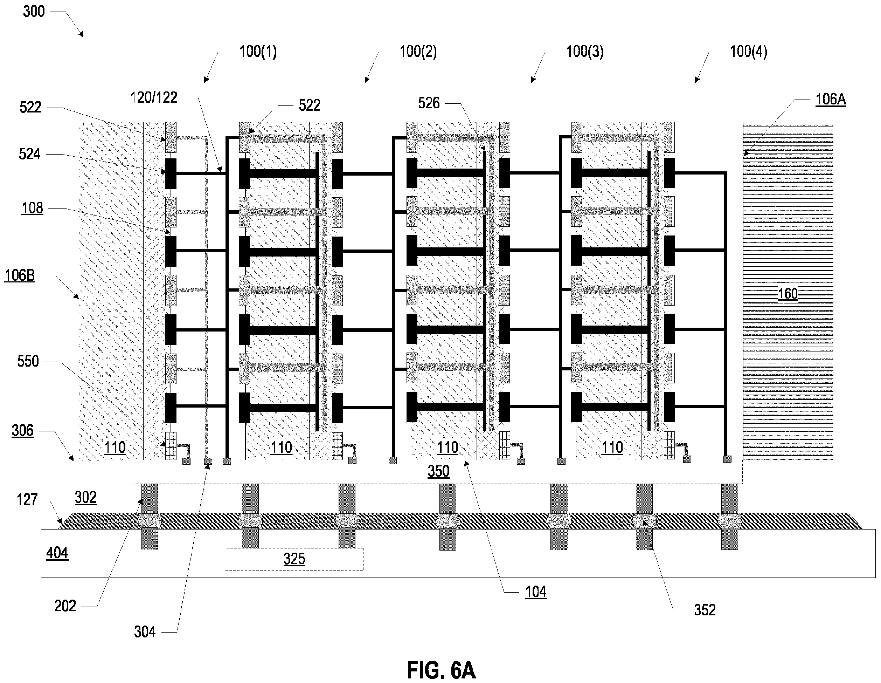

FIG. 5D is a schematic cross-sectional view of an example IC die 100 according to some embodiments of the present disclosure. The embodiment shown in the figure is similar to that of FIG. 5A, except that IC die 100 includes conductive pathways 120(1), 122(1) in metallization stack 102 electrically coupled to Vcc pads 522 at interface 108 and conductive pathways 120(2), 122(2) electrically coupled to Vss pads 524 at interface 108, and does not include an array of Vcc pads 522 and Vss pads 524 at a surface 106B or TSVs 202(1), 202(2). IC die 100 of FIG. 5D may be a first bonded IC die 100 in a series of bonded IC dies 100 (e.g., as shown in FIG. 6A).

FIG. 6A is a schematic cross-sectional view of microelectronic assembly 300 according to some embodiments of the present disclosure. The embodiment shown in the figure is similar to that of FIG. 3A, except IC dies 100 (e.g., IC dies 100(1) through 100(4)) are bonded together at respective surfaces 106 (e.g., surfaces 106A, 160B, as shown in FIGS. 1 and 5), IC die 302 further includes VC circuitry 350, and voltage domains of IC die 100(1) through 100(4) are connected in series (e.g., serially connected, where Vss pad 524 at interface 108 of IC die 100 is connected to Vcc pad 522 at surface 106B of an adjacent IC die 100). IC dies 100 are selected from embodiments at least shown in FIGS. 5A and 5D and may include compute circuitry. In some embodiments, IC die 100 may further include VC circuitry. Microelectronic assembly 300 may further include a package substrate 404 with connections to a power source 325. As described above with reference to FIG. 5, IC die 100 may include an array of Vss pads 524 at interface 108 (e.g., between substrate 110 and metallization stack 102, as shown in FIG. 5) and an array of Vcc pads at surface 106B, where individual ones of the array of Vss pads 524 of an IC die 100 are electrically coupled by conductive pathways 120, 122 through metallization stack 102 to individual ones of the Vcc pads 522 at surface 106B of an adjacent IC die 100 (e.g., IC die 100(1) to IC die 100(2), IC die 100(2) to IC die 100(3), and IC die 100(3) to IC die 100(4)). Vcc in the package substrate 404 may be connected to Vcc 522 of first IC die 100(1). Vss 524 in first IC die 100(1) may be connected to Vcc 522 in an adjacent second IC die 100(2). Vss 524 in second IC die 100(2) may be connected to Vcc 522 in an adjacent third IC die 100(3). Vss 524 in third IC die 100(3) may be connected to Vcc 522 in an adjacent fourth IC die 100(4). Vss 524 in fourth IC die 100(4) may be connected to Vss in the package substrate 404. VC circuitry 350 in IC die 302 may deliver any differential current to IC die 100 through respective conductive traces 120 electrically coupled to surface 306 of IC die 302 by interconnects 304. Although FIG. 6A shows four IC die 100, a microelectronic assembly 300 may have any suitable number and arrangement of IC die 100. For example, a microelectronic assembly 300 may include between fifteen (15) and twenty (20) IC die 100 (e.g., compute dies). Further, although FIG. 6A includes IC die selected from FIGS. 5A and 5D, IC die 100 may include one or more of the embodiments in FIGS. 5A-5D.

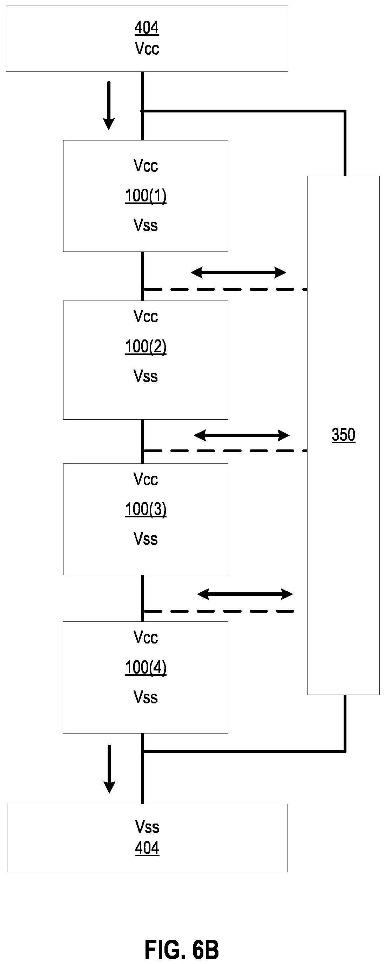

FIG. 6B is a simplified circuit diagram of the microelectronic assembly of FIG. 6A according to some embodiments of the present disclosure. FIG. 6B illustrates the microelectronic assembly 300 in FIG. 6A. Voltage domains of IC die 100(1) through 100(4) may be connected in series (e.g., serially connected, where Vss of IC die 100 is connected to Vcc of an adjacent IC die 100) and any differential current may be delivered to individual IC die 100 by VC circuitry 350 through conductive traces 120 coupled to surface 306 of IC die 302.

Returning to FIG. 6A, IC die 302 may include VC circuitry 350. VC circuitry 350 may include electronic components and circuitry for converting voltage. For example, VC circuitry 350 may include a voltage input, a voltage output, an input capacitor, an output capacitor, an inductor, a switching transistor and/or a diode, and a control circuit having a plurality of transistors to perform voltage conversion. In some embodiments, VC circuitry 350 may be integrated into IC die 302, as shown. In other embodiments, VC circuitry 350 may be a separate IC die coupled to a top surface (e.g., surface 306) of IC die 302, a bottom surface of IC die 302, or on or in package substrate 404. VC circuitry 350 in IC die 302 may convert and deliver power to the IC dies 100(1) through 100(4) in a range between 0.2 volts (V) and 2V. In some embodiments, VC circuitry 350 may include various voltage rails configured to provide current at correspondingly different voltages. VC circuitry 350 may be fabricated using processes particularly suitable for voltage regulator circuitry, such as a special silicon process, or processes using lll-V devices, such as gallium nitride or silicon carbide, for example, to support improved power conversion.

The microelectronic assembly 300 may further include voltage regulator (VR) circuitry (not shown) as part of the power delivery network to maintain a constant voltage. VR circuitry may be integrated in IC die 302, may be a separate VR die coupled to IC die 302, or may be integrated in IC die 100.

The microelectronic assembly 300 may further include a package substrate 404 having a power supply 325. VC circuitry 350 may be coupled to one or more power supply 325 connected to package substrate 404 by TSVs 202 through IC die 302 and by interconnects 352. The one or more power supply 325 in the package substrate 404 may be configured to deliver power to VC circuitry 350 at a higher input voltage (e.g., 12V, 5V, 3.3V, or 1.8V). The package substrate 404 may include an insulating material (e.g., a dielectric material formed in multiple layers, as known in the art) and one or more conductive pathways to route power, ground, and signals through the dielectric material (e.g., including conductive traces and/or conductive vias, as shown). In some embodiments, the insulating material of the package substrate 404 may be a dielectric material, such as an organic dielectric material, a fire retardant grade 4 material (FR-4), BT resin, polyimide materials, glass reinforced epoxy matrix materials, organic dielectrics with inorganic fillers or low-k and ultra low-k dielectric (e.g., carbon-doped dielectrics, fluorine-doped dielectrics, porous dielectrics, and organic polymeric dielectrics). In particular, when the package substrate 404 is formed using standard printed circuit board (PCB) processes, the package substrate 404 may include FR-4, and the conductive pathways in the package substrate 404 may be formed by patterned sheets of copper separated by build-up layers of the FR-4. The conductive pathways in the package substrate 404 may be bordered by liner materials, such as adhesion liners and/or barrier liners, as suitable. In some embodiments, the package substrate 404 may be formed using a lithographically defined via packaging process. In some embodiments, the package substrate 404 may be manufactured using standard organic package manufacturing processes, and thus the package substrate 404 may take the form of an organic package. In some embodiments, the package substrate 404 may be a set of redistribution layers formed on a panel carrier by laminating or spinning on a dielectric material, and creating conductive vias and lines by laser drilling and plating. In some embodiments, the package substrate 404 may be formed on a removable carrier using any suitable technique, such as a redistribution layer technique. Any method known in the art for fabrication of the package substrate 404 may be used, and for the sake of brevity, such methods will not be discussed in further detail herein.

IC die 302 may be coupled to the package substrate 404 by interconnects 352. The interconnects 352 disclosed herein may take any suitable form. When interconnects are described herein, a surface of a first die may include a first set of conductive contacts, and a surface of a second die or a package substrate may include a second set of conductive contacts. One or more conductive contacts of the first set may then be electrically and mechanically coupled to some of the conductive contacts of the second set by the interconnects. In some embodiments, a set of interconnects 352 may include solder (e.g., solder bumps or balls that are subject to a thermal reflow to form the interconnects 352). The interconnects 352 that include solder may include any appropriate solder material, such as lead/tin, tin/bismuth, eutectic tin/silver, ternary tin/silver/copper, eutectic tin/copper, tin/nickel/copper, tin/bismuth/copper, tin/indium/copper, tin/zinc/indium/bismuth, or other alloys. In some embodiments, a set of interconnects 352 may include an anisotropic conductive material, such as an anisotropic conductive film or an anisotropic conductive paste. An anisotropic conductive material may include conductive materials dispersed in a non-conductive material. In some embodiments, an anisotropic conductive material may include microscopic conductive particles embedded in a binder or a thermoset adhesive film (e.g., a thermoset biphenyl-type epoxy resin, or an acrylic-based material). In some embodiments, the conductive particles may include a polymer and/or one or more metals (e.g., nickel or gold). For example, the conductive particles may include nickel-coated gold or silver-coated copper that is in turn coated with a polymer. In another example, the conductive particles may include nickel. When an anisotropic conductive material is uncompressed, there may be no conductive pathway from one side of the material to the other. However, when the anisotropic conductive material is adequately compressed (e.g., by conductive contacts on either side of the anisotropic conductive material), the conductive materials near the region of compression may contact each other so as to form a conductive pathway from one side of the film to the other in the region of compression.

In some embodiments, some of the interconnects in a microelectronic assembly or an IC package as described herein may be metal-to-metal interconnects (e.g., copper-to-copper interconnects, or plated interconnects). In such embodiments, the conductive contacts on either side of the interconnect may be bonded together (e.g., under elevated pressure and/or temperature) without the use of intervening solder or an anisotropic conductive material. In some metal-to-metal interconnects, a dielectric material (e.g., silicon oxide, silicon nitride, silicon carbide) may be present between the metals bonded together (e.g., between copper pads or posts that provide the associated conductive contacts). In some embodiments, one side of an interconnect may include a metal pillar (e.g., a copper pillar), and the other side of the interconnect may include a metal contact (e.g., a copper contact) recessed in a dielectric. In some embodiments, a metal-to-metal interconnect (e.g., a copper-to-copper interconnect) may include a noble metal (e.g., gold) or a metal whose oxides are conductive (e.g., silver). In some embodiments, a metal-to-metal interconnect may include metal nanostructures (e.g., nanorods) that may have a reduced melting point. Metal-to-metal interconnects may be capable of reliably conducting a higher current than other types of interconnects; for example, some solder interconnects may form brittle intermetallic compounds when current flows, and the maximum current provided through such interconnects may be constrained to mitigate mechanical failure.

In some embodiments, a thin cap of solder may be used in a metal-to-metal interconnect to accommodate planarity, and this solder may become an intermetallic compound during processing. In some embodiments, the solder used in some of the interconnects may have a higher melting point than the solder included in other of the interconnects. For example, when the interconnects in an IC package are formed before other interconnects, solder-based interconnects formed first may use a higher-temperature solder (e.g., with a melting point above 200 degrees Celsius), while the interconnects formed second may use a lower-temperature solder (e.g., with a melting point below 200 degrees Celsius). In some embodiments, a higher-temperature solder may include tin; tin and gold; or tin, silver, and copper (e.g., 96.5 % tin, 3% silver, and 0.5% copper). In some embodiments, a lower-temperature solder may include tin and bismuth (e.g., eutectic tin bismuth), tin, silver, bismuth, indium, indium and tin, or gallium.

In some embodiments, the microelectronic assembly 300 may also include an underfill material 127. In some embodiments, the underfill material 127 may extend between a bottom surface of IC die 302 and a top surface of the package substrate 404 around the associated interconnects 352. The underfill material 127 may be an insulating material, such as an appropriate epoxy material. In some embodiments, the underfill material 127 may include a capillary underfill, non-conductive film (NCF), or molded underfill. In some embodiments, the underfill material 127 may include an epoxy flux that assists with soldering IC die 302 to the package substrate 404 when forming the interconnects 352, and then polymerizes and encapsulates the interconnects 352. The underfill material 127 may be selected to have a coefficient of thermal expansion (CTE) that may mitigate or minimize the stress between IC die 302 and the package substrate 404 arising from uneven thermal expansion in the microelectronic assembly 300.

In some embodiments, the microelectronic assembly 300 may also include a circuit board (not shown). The package substrate 404 may be coupled to the circuit board by interconnects (not shown) at the bottom surface of the package substrate 404. The interconnects may be any suitable interconnects, including solder balls for a ball grid array arrangement, pins in a pin grid array arrangement or lands in a land grid array arrangement. The circuit board may be a motherboard, for example, and may have other components attached to it. The circuit board may include conductive pathways and other conductive contacts for routing power, ground, and signals through the circuit board, as known in the art. In some embodiments, the interconnects may not couple the package substrate 404 to a circuit board, but may instead couple the package substrate 404 to another IC package, an interposer, or any other suitable component.

The microelectronic assembly 300 may further include a cooling apparatus 160. IC die 100 may create varying amounts of heat on a surface and a varying amount of heat as a function of time. Vertically stacked IC die 100 may limit or prevent heat transfer. A cooling apparatus 160 may include any suitable cooling apparatus that dissipates and/or transfers heat away from IC die 100. For example, a cooling apparatus 160 may include a heat spreader, a heat sink, or other thermally conductive material. In some embodiments, a cooling apparatus 160 may include a thermally conductive material with microchannels (not shown) that are hollow (e.g., an open structure allowing air to flow through) or that include a fluid. The fluid may be circulated using a pump or a fan, which may be a separate piece of equipment or may be part of a cooling apparatus 160. The microelectronic assembly 300 may further include pipes or connections to a heat exchanger, a chiller, or other device for cooling the fluid (not shown) before returning the fluid to the cooling apparatus 160. The fluid may be any suitable liquid or gas, such as a coolant (e.g., water, fluorochemical liquids, silicone oil, ethylene glycol water, poly-alpha-olefin, or silicate ester), or air, helium, argon, or nitrogen, that may be circulated, usually by a pump or a fan, to dissipate heat more efficiently from IC die 100. The fluid may also include additives to prevent corrosion of the different components or to allow operation at higher/lower temperatures (e.g., additives to water to decrease its freezing point or increase its boiling point). The coolant used may depend on the coolant's properties, including viscosity and heat capacity, circulation flow rate, and the temperature rise during device operation. In some embodiments, the fluid may be an electronic coolant liquid or a dielectric fluid that is electrically insulating, highly thermally stable, nontoxic, chemically inert, non-corrosive with high thermal conductivity. A dielectric fluid may include a dielectric material in a liquid state. For example, the fluid may be an ultra-low-viscosity dielectric heat transfer fluid that includes synthetic hydrocarbon oils. In some embodiments, the fluid may not include sulfur. In some embodiments, the fluid may include a transformer oil, perfluoroalkanes, and purified water.

FIG. 7 is a schematic cross-sectional view of microelectronic assembly 300 according to some embodiments of the present disclosure. The embodiment shown in the figure is substantially similar to that of FIG. 6A, except that microelectronic assembly 300 includes multiple serially connected IC die 100 (e.g., serially connected IC die 100(1) through 100(3) and serially connected IC die 100(4) through 100(6)) having dedicated VC circuitry 350(1), 350(2) in IC die 302 and dedicated power supply 325(1), 325(2) connections in package substrate 404. Microelectronic assembly 300 further includes multiple cooling apparatuses 160(1), 160(2). Although FIG. 7 shows a particular number and arrangement of IC die 100, VC circuitry 350, cooling apparatus 160, and power supply 325, a microelectronic assembly 300 may have any suitable number and arrangement of IC die 100, VC circuitry 350, cooling apparatus 160, and power supply 325 for converting and delivering power to IC die 100.

FIG. 8A is a schematic cross-sectional view of another example microelectronic assembly 300 according to some embodiments of the present disclosure. The embodiment shown in the figure is similar to that of FIG. 6A, except that microelectronic assembly 300 further includes IC die 100A(1) through 100A(3) between respective IC die 100(1) through 100(3), where voltage domains of IC die 100 are serially connected. IC die 100A may include an array of capacitors 164 in substrate 110 (e.g., array of capacitors 164(1) through 164(3), respectively), and may not include compute circuitry. In some embodiments, VC circuitry 350 in IC die 302 may use capacitor-based voltage conversion. In such embodiments, VC circuitry 350 may convert and deliver power to IC die 100 using capacitors 164 in IC die 100A. The array of capacitors 164 may include any suitable number and type of capacitors, including, for example, metal-oxide-semiconductor (MOS) capacitors, metal-oxide-metal (MOM) capacitors, metal-insulator-metal (MIM) capacitors, and/or deep trench capacitors (DTC), among others. In some embodiments, VC circuitry 350 may further use in-package capacitors that are on a land side, a die side, or embedded in a package substrate. In some embodiments, VC circuitry 350 in IC die 302 also may use inductor-based voltage conversion. In such embodiments, package substrate 404 may further include inductors 166. Inductors 166 may include any suitable number and type of inductors, and may be integrated using metal layers and incorporating magnetic material.

FIG. 8B is a magnified portion of the microelectronic assembly of FIG. 8A that includes IC die 100(1), 100(2) and IC die 100A(2). As shown in FIG. 8B, IC die 100A may include an array of Vcc pads 522 and Vss pads 524 at surface 106B of substrate 110 and at interface 108 (e.g., between active region 112 and metallization stack 102). The array of Vcc pads 522 and Vss pads 524 may include alternating rows of Vcc pads 522 and Vss pads 524. Some of the TSVs 202 may electrically couple individual ones of the array of Vcc pads 522 at surface 106B to individual ones of the array of Vcc pads 522 at interface 108 and some of the TSVs 202 may electrically couple individual ones of the array of Vss pads 524 at surface 106B to individual ones of the array of Vss pads 522 at interface 108. As described above, a TSV 202 may extend from surface 106B to interface 108 or TSV 202 may be coupled to one or more metal layers (e.g., metal layer 526 in FIG. 5A and/or metal layer 528 in FIG. 5C). IC die 100A (e.g., IC die 100A(2) in FIG. 8B) may include conductive pathways 120/122 through metallization stack 102 that electrically couple individual ones of the array of Vcc pads 522 at the interface 108 to individual ones of the array of Vcc pads 522 at surface 106B of an adjacent IC die 100 (e.g., IC die 100(2) in FIG. 8B). IC die 100A (e.g., IC die 100A(2) in FIG. 8B) may further include conductive pathways 120/122 through metallization stack 102 that electrically couple individual ones of the array of Vss pads 524 at the interface 108 to individual ones of the array of Vss pads 524 at surface 106B of the adjacent IC die 100 (e.g., IC die 100(2) in FIG. 8B).

FIG. 8C is a simplified circuit diagram of the microelectronic assembly of FIG. 8A according to some embodiments of the present disclosure. FIG. 8C illustrates the microelectronic assembly 300 in FIG. 8A having capacitor-based voltage conversion. Voltage domains of IC die 100 may be connected in series and any differential current may be delivered to individual IC die 100 by VC circuitry 350 through conductive traces 120 coupled to surface 306 of IC die 302. IC die 100A including array of capacitors 164(1) through 164(3) may be used for the purpose of decoupling and may be used by VC circuitry 350 based on capacitive topologies, such as fixed-ratio dividers (e.g., 2:1, 4:1, etc.), continuously scalable conversion-ratio topologies, and derivatives.

In various embodiments, any of the features discussed with reference to any of FIGS. 1-8 herein may be combined with any other features to form a package with one or more IC dies as described herein, for example, to form a modified IC die 100 or a modified microelectronic assembly 300. Some such combinations are described above, but, in various embodiments, further combinations and modifications are possible. Various different embodiments described in different figures may be combined suitably based on particular needs within the broad scope of the embodiments.

### Example devices and components

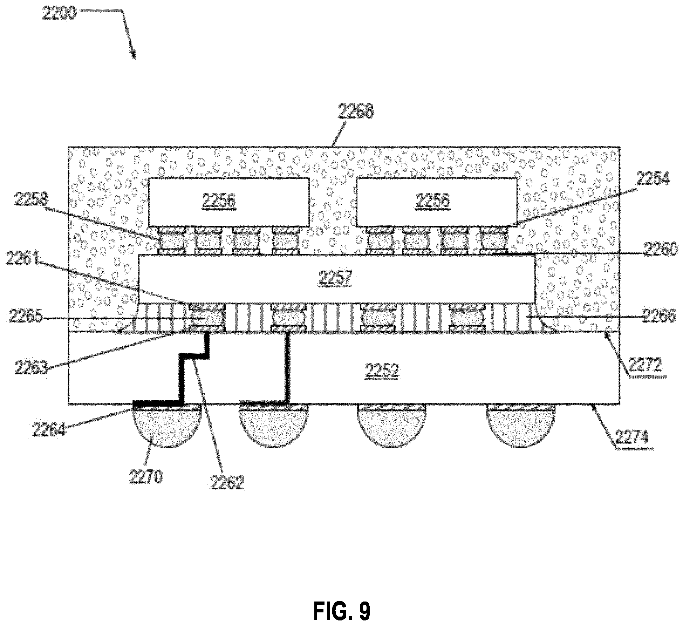

The packages disclosed herein, e.g., any of the embodiments shown in FIGS. 1-8 or any further embodiments described herein, may be included in any suitable electronic component. FIGS. 9-11 illustrate various examples of packages, assemblies, and devices that may be used with or include any of the IC packages as disclosed herein.

FIG. 9 is a side, cross-sectional view of an example IC package 2200 that may include IC packages in accordance with any of the embodiments disclosed herein. In some embodiments, the IC package 2200 may be a SiP.

As shown in the figure, package substrate 2252 may be formed of an insulator (e.g., a ceramic, a buildup film, an epoxy film having filler particles therein, etc.), and may have conductive pathways extending through the insulator between first face 2272 and second face 2274, or between different locations on first face 2272, and/or between different locations on second face 2274. These conductive pathways may take the form of any of the interconnect structures comprising lines and/or vias.

Package substrate 2252 may include conductive contacts 2263 that are coupled to conductive pathway 2262 through package substrate 2252, allowing circuitry within dies 2256 and/or interposer 2257 to electrically couple to various ones of conductive contacts 2264 (or to other devices included in package substrate 2252, not shown).

IC package 2200 may include interposer 2257 coupled to package substrate 2252 via conductive contacts 2261 of interposer 2257, first-level interconnects 2265, and conductive contacts 2263 of package substrate 2252. First-level interconnects 2265 illustrated in the figure are solder bumps, but any suitable first-level interconnects 2265 may be used, such as solder bumps, solder posts, or bond wires.

IC package 2200 may include one or more dies 2256 coupled to interposer 2257 via conductive contacts 2254 of dies 2256, first-level interconnects 2258, and conductive contacts 2260 of interposer 2257. Conductive contacts 2260 may be coupled to conductive pathways (not shown) through interposer 2257, allowing circuitry within dies 2256 to electrically couple to various ones of conductive contacts 2261 (or to other devices included in interposer 2257, not shown). First-level interconnects 2258 illustrated in the figure are solder bumps, but any suitable first-level interconnects 2258 may be used, such as solder bumps, solder posts, or bond wires. As used herein, a "conductive contact" may refer to a portion of electrically conductive material (e.g., metal) serving as an interface between different components; conductive contacts may be recessed in, flush with, or extending away from a surface of a component, and may take any suitable form (e.g., a conductive pad or socket).

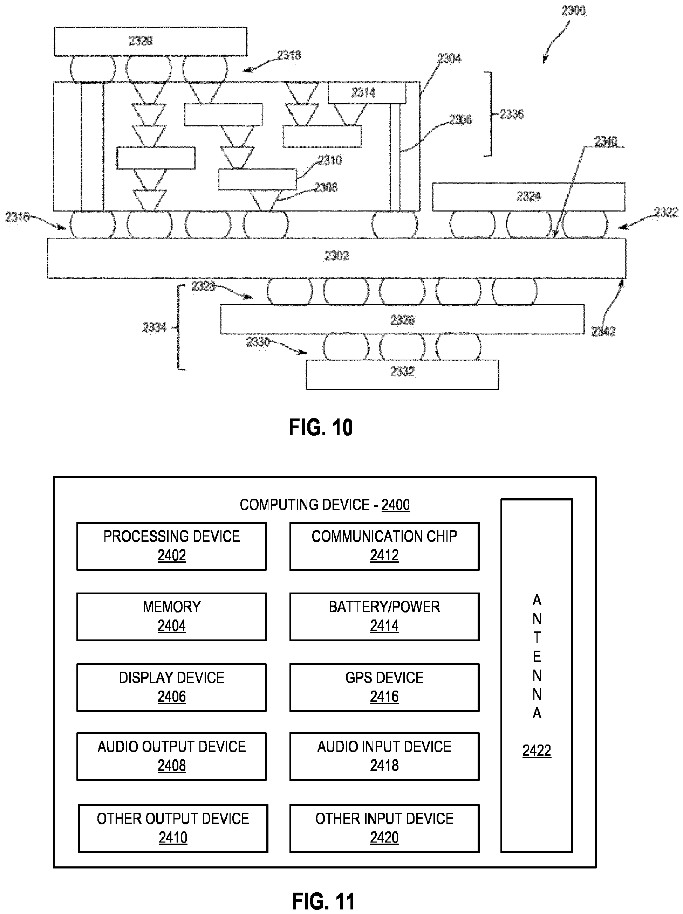

In some embodiments, underfill material 2266 may be disposed between package substrate 2252 and interposer 2257 around first-level interconnects 2265, and mold 2268 may be disposed around dies 2256 and interposer 2257 and in contact with package substrate 2252. In some embodiments, underfill material 2266 may be the same as mold 2268. Example materials that may be used for underfill material 2266 and mold 2268 are epoxies as suitable. Second-level interconnects 2270 may be coupled to conductive contacts 2264. Second-level interconnects 2270 illustrated in the figure are solder balls (e.g., for a ball grid array (BGA) arrangement), but any suitable second-level interconnects 2270 may be used (e.g., pins in a pin grid array arrangement or lands in a land grid array arrangement). Second-level interconnects 2270 may be used to couple IC package 2200 to another component, such as a circuit board (e.g., a motherboard), an interposer, or another IC package, as known in the art and as discussed below with reference to FIG. 10.

In various embodiments, any of dies 2256 may be microelectronic assembly 300 as described herein. In embodiments in which IC package 2200 includes multiple dies 2256, IC package 2200 may be referred to as a multi-chip package (MCP). Dies 2256 may include circuitry to perform any desired functionality. For example, besides one or more of dies 2256 being microelectronic assembly 300 as described herein, one or more of dies 2256 may be logic dies (e.g., silicon-based dies), one or more of dies 2256 may be memory dies (e.g., HBM), etc. In some embodiments, any of dies 2256 may be implemented as discussed with reference to any of the previous figures. In some embodiments, at least some of dies 2256 may not include implementations as described herein.

Although IC package 2200 illustrated in the figure is a flip-chip package, other package architectures may be used. For example, IC package 2200 may be a BGA package, such as an embedded wafer-level ball grid array (eWLB) package. In another example, IC package 2200 may be a wafer-level chip scale package (WLCSP) or a panel fan-out (FO) package. Although two dies 2256 are illustrated in IC package 2200, IC package 2200 may include any desired number of dies 2256. IC package 2200 may include additional passive components, such as surface-mount resistors, capacitors, and inductors disposed over first face 2272 or second face 2274 of package substrate 2252, or on either face of interposer 2257. More generally, IC package 2200 may include any other active or passive components known in the art.

In some embodiments, no interposer 2257 may be included in IC package 2200; instead, dies 2256 may be coupled directly to conductive contacts 2263 at first face 2272 by first-level interconnects 2265.

FIG. 10 is a cross-sectional side view of an IC device assembly 2300 that may include components having one or more microelectronic assembly 300 in accordance with any of the embodiments disclosed herein. IC device assembly 2300 includes a number of components disposed over a circuit board 2302 (which may be, e.g., a motherboard). IC device assembly 2300 includes components disposed over a first face 2340 of circuit board 2302 and an opposing second face 2342 of circuit board 2302; generally, components may be disposed over one or both faces 2340 and 2342. In particular, any suitable ones of the components of IC device assembly 2300 may include any of the one or more microelectronic assembly 300 in accordance with any of the embodiments disclosed herein; e.g., any of the IC packages discussed below with reference to IC device assembly 2300 may take the form of any of the embodiments of IC package 2200 discussed above with reference to FIG. 9.

In some embodiments, circuit board 2302 may be a PCB including multiple metal layers separated from one another by layers of insulator and interconnected by electrically conductive vias. Any one or more of the metal layers may be formed in a desired circuit pattern to route electrical signals (optionally in conjunction with other metal layers) between the components coupled to circuit board 2302. In other embodiments, circuit board 2302 may be a non-PCB package substrate.

As illustrated in the figure, in some embodiments, IC device assembly 2300 may include a package-on-interposer structure 2336 coupled to first face 2340 of circuit board 2302 by coupling components 2316. Coupling components 2316 may electrically and mechanically couple package-on-interposer structure 2336 to circuit board 2302, and may include solder balls (as shown), male and female portions of a socket, an adhesive, an underfill material, and/or any other suitable electrical and/or mechanical coupling structure.

Package-on-interposer structure 2336 may include IC package 2320 coupled to interposer 2304 by coupling components 2318. Coupling components 2318 may take any suitable form depending on desired functionalities, such as the forms discussed above with reference to coupling components 2316. In some embodiments, IC package 2320 may be or include IC package 2200, e.g., as described above with reference to FIG. 9. In some embodiments, IC package 2320 may include at least one microelectronic assembly 300 as described herein. Microelectronic assembly 300 is not specifically shown in the figure in order to not clutter the drawing.

Although a single IC package 2320 is shown in the figure, multiple IC packages may be coupled to interposer 2304; indeed, additional interposers may be coupled to interposer 2304. Interposer 2304 may provide an intervening package substrate used to bridge circuit board 2302 and IC package 2320. Generally, interposer 2304 may redistribute a connection to a wider pitch or reroute a connection to a different connection. For example, interposer 2304 may couple IC package 2320 to a BGA of coupling components 2316 for coupling to circuit board 2302.

In the embodiment illustrated in the figure, IC package 2320 and circuit board 2302 are attached to opposing sides of interposer 2304. In other embodiments, IC package 2320 and circuit board 2302 may be attached to a same side of interposer 2304. In some embodiments, three or more components may be interconnected by way of interposer 2304.

Interposer 2304 may be formed of an epoxy resin, a fiberglass-reinforced epoxy resin, a ceramic material, or a polymer material such as polyimide. In some implementations, interposer 2304 may be formed of alternate rigid or flexible materials that may include the same materials described above for use in a semiconductor substrate, such as silicon, germanium, and other group lll-V and group IV materials. Interposer 2304 may include metal interconnects 2308 and vias 2310, including but not limited to TSVs 2306. Interposer 2304 may further include embedded devices 2314, including both passive and active devices. Such devices may include, but are not limited to, capacitors, decoupling capacitors, resistors, inductors, fuses, diodes, transformers, sensors, ESD devices, and memory devices. More complex devices such as radio frequency (RF) devices, power amplifiers, power management devices, antennas, arrays, sensors, and microelectromechanical systems (MEMS) devices may also be formed on interposer 2304. Package-on-interposer structure 2336 may take the form of any of the package-on-interposer structures known in the art.

In some embodiments, IC device assembly 2300 may include an IC package 2324 coupled to first face 2340 of circuit board 2302 by coupling components 2322. Coupling components 2322 may take the form of any of the embodiments discussed above with reference to coupling components 2316, and IC package 2324 may take the form of any of the embodiments discussed above with reference to IC package 2320.

In some embodiments, IC device assembly 2300 may include a package-on-package structure 2334 coupled to second face 2342 of circuit board 2302 by coupling components 2328. Package-on-package structure 2334 may include an IC package 2326 and an IC package 2332 coupled together by coupling components 2330 such that IC package 2326 is disposed between circuit board 2302 and IC package 2332. Coupling components 2328 and 2330 may take the form of any of the embodiments of coupling components 2316 discussed above, and IC packages 2326 and/or 2332 may take the form of any of the embodiments of IC package 2320 discussed above. Package-on-package structure 2334 may be configured in accordance with any of the package-on-package structures known in the art.

FIG. 11 is a block diagram of an example computing device 2400 that may include one or more components having one or more IC packages in accordance with any of the embodiments disclosed herein. For example, any suitable ones of the components of computing device 2400 may include a microelectronic assembly in accordance with any of the embodiments disclosed herein. In another example, any one or more of the components of computing device 2400 may include any embodiments of IC package 2200 (e.g., as shown in FIG. 9). In yet another example, any one or more of the components of computing device 2400 may include an IC device assembly 2300 (e.g., as shown in FIG. 10).

A number of components are illustrated in the figure as included in computing device 2400, but any one or more of these components may be omitted or duplicated, as suitable for the application. In some embodiments, some or all of the components included in computing device 2400 may be attached to one or more motherboards. In some embodiments, some or all of these components are fabricated onto a single system-on-chip (SOC) die.

Additionally, in various embodiments, computing device 2400 may not include one or more of the components illustrated in the figure, but computing device 2400 may include interface circuitry for coupling to the one or more components. For example, computing device 2400 may not include a display device 2406, but may include display device interface circuitry (e.g., a connector and driver circuitry) to which display device 2406 may be coupled. In another set of examples, computing device 2400 may not include an audio input device 2418 or an audio output device 2408, but may include audio input or output device interface circuitry (e.g., connectors and supporting circuitry) to which audio input device 2418 or audio output device 2408 may be coupled.

Computing device 2400 may include a processing device 2402 (e.g., one or more processing devices). As used herein, the term "processing device" or "processor" may refer to any device or portion of a device that processes electronic data from registers and/or memory to transform that electronic data into other electronic data that may be stored in registers and/or memory. Processing device 2402 may include one or more DSPs, ASICs, CPUs, GPUs, cryptoprocessors (specialized processors that execute cryptographic algorithms within hardware), server processors, or any other suitable processing devices. Computing device 2400 may include a memory 2404, which may itself include one or more memory devices such as volatile memory (e.g., dynamic random access memory (DRAM)), nonvolatile memory (e.g., read-only memory (ROM)), flash memory, solid-state memory, and/or a hard drive. In some embodiments, memory 2404 may include memory that shares a die with processing device 2402. This memory may be used as cache memory and may include embedded dynamic random access memory (eDRAM) or spin transfer torque magnetic random access memory (STT-MRAM).

In some embodiments, computing device 2400 may include a communication chip 2412 (e.g., one or more communication chips). For example, communication chip 2412 may be configured for managing wireless communications for the transfer of data to and from computing device 2400. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

Communication chip 2412 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), LTE project along with any amendments, updates, and/or revisions (e.g., advanced LTE project, ultramobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication chip 2412 may operate in accordance with a Global System for Mobile Communication (GSM), General Packet Radio Service (GPRS), Universal Mobile Telecommunications System (UMTS), High-Speed Packet Access (HSPA), Evolved HSPA (E-HSPA), or LTE network. The communication chip 2412 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). Communication chip 2412 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. Communication chip 2412 may operate in accordance with other wireless protocols in other embodiments. Computing device 2400 may include an antenna 2422 to facilitate wireless communications and/or to receive other wireless communications (such as AM or FM radio transmissions).

In some embodiments, communication chip 2412 may manage wired communications, such as electrical, optical, or any other suitable communication protocols (e.g., the Ethernet). As noted above, communication chip 2412 may include multiple communication chips. For instance, a first communication chip 2412 may be dedicated to shorter-range wireless communications such as Wi-Fi or Bluetooth, and a second communication chip 2412 may be dedicated to longer-range wireless communications such as global positioning system (GPS), EDGE, GPRS, CDMA, WiMAX, LTE, EV-DO, or others. In some embodiments, a first communication chip 2412 may be dedicated to wireless communications, and a second communication chip 2412 may be dedicated to wired communications.

Computing device 2400 may include battery/power circuitry 2414. Battery/power circuitry 2414 may include one or more energy storage devices (e.g., batteries or capacitors) and/or circuitry for coupling components of computing device 2400 to an energy source separate from computing device 2400 (e.g., AC line power).

Computing device 2400 may include a display device 2406 (or corresponding interface circuitry, as discussed above). Display device 2406 may include any visual indicators, such as a heads-up display, a computer monitor, a projector, a touchscreen display, a liquid crystal display (LCD), a light-emitting diode display, or a flat panel display, for example.

Computing device 2400 may include audio output device 2408 (or corresponding interface circuitry, as discussed above). Audio output device 2408 may include any device that generates an audible indicator, such as speakers, headsets, or earbuds, for example.

Computing device 2400 may include audio input device 2418 (or corresponding interface circuitry, as discussed above). Audio input device 2418 may include any device that generates a signal representative of a sound, such as microphones, microphone arrays, or digital instruments (e.g., instruments having a musical instrument digital interface (MIDI) output).

Computing device 2400 may include a GPS device 2416 (or corresponding interface circuitry, as discussed above). GPS device 2416 may be in communication with a satellite-based system and may receive a location of computing device 2400, as known in the art.

Computing device 2400 may include other output device 2410 (or corresponding interface circuitry, as discussed above). Examples of other output device 2410 may include an audio codec, a video codec, a printer, a wired or wireless transmitter for providing information to other devices, or an additional storage device.

Computing device 2400 may include other input device 2420 (or corresponding interface circuitry, as discussed above). Examples of other input device 2420 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

Computing device 2400 may have any desired form factor, such as a handheld or mobile computing device (e.g., a cell phone, a smart phone, a mobile internet device, a music player, a tablet computer, a laptop computer, a netbook computer, an ultrabook computer, a personal digital assistant (PDA), an ultramobile personal computer, etc.), a desktop computing device, a server or other networked computing component, a printer, a scanner, a monitor, a set-top box, an entertainment control unit, a vehicle control unit, a digital camera, a digital video recorder, or a wearable computing device. In some embodiments, computing device 2400 may be any other electronic device that processes data.

### Select examples

The descriptions of illustrated implementations of the disclosure, including what is described in the abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize.

The following paragraphs provide various examples of the embodiments disclosed herein.

Example 1 is an integrated circuit (IC) die, including a substrate, the substrate including a first surface, a second surface opposite the second surface, a third surface orthogonal to the first and second surfaces, and through substrate vias (TSVs) orthogonal to the first and second surfaces, the first surface having an array of first conductive pads electrically coupled to the TSVs; and a metallization stack having a fourth surface, a fifth surface opposite the fourth surface, and a sixth surface orthogonal to the fourth and fifth surfaces, the metallization stack including a conductive trace parallel to the fourth and fifth surfaces and exposed at the sixth surface, and conductive vias between the fourth and fifth surfaces and exposed at the fifth surface, wherein the second surface of the substrate is coupled to the fourth surface of the metallization stack, and an interface between the substrate and the metallization stack includes an array of second conductive pads electrically coupled to the conductive trace and conductive vias in the metallization stack.

Example 2 may include the subject matter of Example 1, and may further specify that the array of first conductive pads are configured to be coupled to a positive power supply voltage.

Example 3 may include the subject matter of Example 1 or 2, and may further specify that the array of second conductive pads are configured to be coupled to a ground or zero power supply voltage.

Example 4 may include the subject matter of Example 2, and may further specify that some of the first conductive pads in the array of first conductive pads are configured to be coupled to the positive power supply voltage and some of the first conductive pads in the array of first conductive pads are configured to be coupled to a ground or zero power supply voltage.

Example 5 may include the subject matter of Example 3, and may further specify that some of the second conductive pads in the array of second conductive pads are configured to be coupled to the ground or zero power supply voltage and some of the second conductive pads in the array of second conductive pads are configured to be coupled to a positive power supply voltage.

Example 6 may include the subject matter of any of Examples 1-3, and may further specify that an individual one of the array of first conductive pads is electrically coupled to an individual one of the TSVs.

Example 7 may include the subject matter of any of Examples 1-3, and may further specify that the substrate further includes a metal layer adjacent to the first surface, and the metal layer electrically couples two or more first conductive pads of the array of first conductive pads to an individual one of the TSVs.

Example 8 may include the subject matter of any of Examples 1-3, and may further specify that the substrate further includes a metal layer adjacent to the second surface and the TSVs are electrically coupled to the metal layer.

Example 9 may include the subject matter of any of Examples 1-3, and may further specify that the TSVs extend through the substrate from the first surface of the substrate to the second surface of the substrate.

Example 10 may include the subject matter of any of Examples 1-3, and may further include compute circuitry.

Example 11 is a microelectronic assembly, including a plurality of first integrated circuit (IC) die, the first IC die including a substrate including a first surface having an array of first conductive pads and through substrate vias (TSVs) electrically coupled to the array of first conductive pads, the substrate including compute circuitry; and a metallization stack having a second surface and a third surface orthogonal to the second surface and including conductive vias exposed at the second surface and a conductive trace exposed at the third surface, wherein the metallization stack is coupled to the substrate and an interface between the substrate and the metallization stack is parallel to the first and second surfaces, and wherein the interface includes an array of second conductive pads electrically coupled to the conductive vias, and wherein the plurality of first IC die are bonded together at respective first and second surfaces and conductive vias exposed at the second surface of one of the plurality of first IC die are electrically coupled to the array of first conductive pads at the first surface of an adjacent one of the plurality of first IC die; and a second IC die having a fourth surface, the second IC die including VC circuitry, wherein the conductive trace exposed at the third surface of the plurality of first IC die is electrically coupled to the fourth surface of the second IC die.

Example 12 may include the subject matter of Example 11, and may further specify that the array of first conductive pads are configured to be coupled to a positive power supply voltage.

Example 13 may include the subject matter of Example 11 or 12, and may further specify that the array of second conductive pads are configured to be coupled to a ground or zero power supply voltage.

Example 14 may include the subject matter of Example 12, and may further specify that the first surface of the substrate further includes an array of third conductive pads configured to be coupled to a ground or zero power supply voltage.

Example 15 may include the subject matter of Example 13, and may further specify that the interface between the substrate and the metallization stack further includes an array of fourth conductive pads configured to be coupled to a positive power supply voltage.

Example 16 may include the subject matter of any of Examples 11-15, and may further specify that the substrate further includes a metal layer adjacent to the second surface and the TSVs are electrically coupled to the metal layer.

Example 17 may include the subject matter of any of Examples 11-15, and may further specify that the TSVs extend through the substrate from the first surface of the substrate to the second surface of the substrate.

Example 18 may include the subject matter of any of Examples 11-17 and may further specify that the second IC die further includes a fifth surface opposite the fourth surface, and the microelectronic assembly may further include a package substrate electrically coupled to the fifth surface of the second IC die.

Example 19 may include the subject matter of Example 18, and may further specify that the package substrate further includes a connection to a power source.

Example 20 is a microelectronic assembly, including a plurality of first integrated circuit (IC) die, the first IC die including a substrate having a first surface and including through substrate vias (TSVs) orthogonal to the first surface, the first surface including an array of first conductive pads and second conductive pads, wherein the through substrate vias (TSVs) are electrically coupled to the array of first conductive pads and second conductive pads; and a metallization stack having a second surface and a third surface orthogonal to the second surface and including conductive vias exposed at the second surface and a conductive trace exposed at the third surface, wherein the metallization stack is coupled to the substrate and an interface between the substrate and the metallization stack is parallel to the first and second surfaces, the interface including the array of first conductive pads and second conductive pads, wherein the conductive vias are electrically coupled to the array of second conductive pads; and wherein some of the TSVs electrically couple the array of first conductive pads at the first surface of the substrate to the array of first conductive pads at the interface between the substrate and the metallization stack, some of the TSVs electrically couple the array of second conductive pads at the first surface of the substrate to the array of second conductive pads at the interface between the substrate and the metallization stack, the plurality of first IC die are bonded together at respective first and second surfaces, and the conductive vias exposed at the second surfaces of the plurality of first IC die are electrically coupled to the array of first conductive pads at the first surface of an adjacent one of the plurality of first IC die; and a second IC die having a fourth surface and including VC circuitry, wherein the conductive trace exposed at the third surface of the plurality of first IC die is electrically coupled to the fourth surface of the second IC die.

Example 21 may include the subject matter of Example 20, and may further specify that the arrays of first conductive pads are configured to be coupled to a positive power supply voltage and the arrays of second conductive pads are configured to be coupled to a ground or zero power supply voltage.

Example 22 may include the subject matter of Example 20 or 21, and may further specify that the plurality of first IC die include compute circuitry.

Example 23 may include the subject matter of any of Examples 20-22, and may further specify that the substrate further includes a metal layer adjacent to the second surface and the TSVs are electrically coupled to the metal layer.

Example 24 may include the subject matter of any of Examples 20-22, and may further specify that the TSVs extend through the substrate from the first surface of the substrate to the interface.

Example 25 may include the subject matter of any of Examples 20-24, and may further include a third IC die having an array of capacitors and including a second substrate having a first surface and including through substrate vias (TSVs) orthogonal to the first surface, the first surface including the array of first conductive pads and second conductive pads, wherein the through substrate vias (TSVs) are electrically coupled to the array of first conductive pads and second conductive pads; and a second metallization stack having a second surface and a third surface orthogonal to the second surface and including second conductive vias exposed at the second surface, wherein the second metallization stack is coupled to the second substrate and an interface between the second substrate and the second metallization stack is parallel to the first and second surfaces, wherein the interface includes the array of first conductive pads and second conductive pads, wherein some of the second conductive vias electrically couple the array of first conductive pads at the first surface to the array of first conductive pads at the interface and some of the second conductive vias electrically couple the array of second conductive pads at the first surface to the array of second conductive pads at the interface, and wherein the third IC die is between individual ones of the plurality of first IC die and is bonded at respective first and second surfaces to the adjacent ones of the plurality of first IC die, and wherein the second conductive vias exposed at the second surface of the third IC die are electrically coupled to the array of second conductive pads at the first surface of an adjacent one of the plurality of first IC die.

Example 26 may include the subject matter of any of Examples 20-25, and may further specify that the second IC die further includes a fifth surface opposite the fourth surface, and the microelectronic assembly may further include a package substrate electrically coupled to the fifth surface of the second IC die.

Example 27 may include the subject matter of Example 26, and may further specify that the package substrate further includes a connection to a power source.

Example 28 may include the subject matter of Example 26 or 27, and may further specify that the package substrate further includes an inductor.

Example 29 may include the subject matter of any of Examples 20-28, and may further include a cooling apparatus.

## Claims

1. An integrated circuit (IC) die, comprising:
a substrate including a first surface, a second surface opposite the second surface, a third surface orthogonal to the first and second surfaces, and through substrate vias (TSVs) orthogonal to the first and second surfaces, the first surface having an array of first conductive pads electrically coupled to the TSVs; and
a metallization stack having a fourth surface, a fifth surface opposite the fourth surface, and a sixth surface orthogonal to the fourth and fifth surfaces, the metallization stack including a conductive trace parallel to the fourth and fifth surfaces and exposed at the sixth surface, and conductive vias between the fourth and fifth surfaces and exposed at the fifth surface, wherein:
the second surface of the substrate is coupled to the fourth surface of the metallization stack, and
an interface between the substrate and the metallization stack includes an array of second conductive pads electrically coupled to the conductive trace and conductive vias in the metallization stack.

2. The IC die of claim 1, wherein the array of first conductive pads are configured to be coupled to a positive power supply voltage.

3. The IC die of claim 1, wherein the array of second conductive pads are configured to be coupled to a ground or zero power supply voltage.

4. The IC die of claim 2, wherein some of the first conductive pads in the array of first conductive pads are configured to be coupled to the positive power supply voltage and some of the first conductive pads in the array of first conductive pads are configured to be coupled to a ground or zero power supply voltage.

5. The IC die of claim 3, wherein some of the second conductive pads in the array of second conductive pads are configured to be coupled to the ground or zero power supply voltage and some of the second conductive pads in the array of second conductive pads are configured to be coupled to a positive power supply voltage.

6. The IC die of any one of claims 1-5, wherein an individual one of the array of first conductive pads is electrically coupled to an individual one of the TSVs.

7. The IC die of any one of claims1-6, wherein the substrate further includes a metal layer adjacent to the first surface, and the metal layer electrically couples two or more first conductive pads of the array of first conductive pads to an individual one of the TSVs.

8. The IC die of any one of claims 1-7, wherein the substrate further includes a metal layer adjacent to the second surface and the TSVs are electrically coupled to the metal layer.

9. The IC die of any one of claims 1-8, wherein the TSVs extend through the substrate from the first surface of the substrate to the second surface of the substrate.

10. The IC die of any one of claims 1-9, further comprising:
compute circuitry.

11. A microelectronic assembly, comprising:
a plurality of first integrated circuit (IC) die including:
a substrate including a first surface having an array of first conductive pads and through substrate vias (TSVs) electrically coupled to the array of first conductive pads, the substrate including compute circuitry; and
a metallization stack having a second surface and a third surface orthogonal to the second surface and including conductive vias exposed at the second surface and a conductive trace exposed at the third surface, wherein the metallization stack is coupled to the substrate and an interface between the substrate and the metallization stack is parallel to the first and second surfaces, and wherein the interface includes an array of second conductive pads electrically coupled to the conductive vias, and
wherein the plurality of first IC die are bonded together at respective first and second surfaces and conductive vias exposed at the second surface of one of the plurality of first IC die are electrically coupled to the array of first conductive pads at the first surface of an adjacent one of the plurality of first IC die; and
a second IC die having a fourth surface, the second IC die including VC circuitry, wherein the conductive trace exposed at the third surface of the plurality of first IC dies is electrically coupled to the fourth surface of the second IC die.

12. The microelectronic assembly of claim 11, wherein the array of first conductive pads are configured to be coupled to a positive power supply voltage.

13. The microelectronic assembly of claim 11, wherein the array of second conductive pads are configured to be coupled to a ground or zero power supply voltage.

14. The microelectronic assembly of claim 12, wherein the first surface of the substrate further includes an array of third conductive pads configured to be coupled to a ground or zero power supply voltage.

15. The microelectronic assembly of claim 13, wherein the interface between the substrate and the metallization stack further includes an array of fourth conductive pads configured to be coupled to a positive power supply voltage.
